(19) **Europäisches Patentamt / European Patent Office / Office européen des brevets**

(11) **EP 2 009 148 A1**

(12) **EUROPEAN PATENT APPLICATION**
published in accordance with Art. 153(4) EPC

(43) Date of publication:
**31.12.2008 Bulletin 2009/01**

(21) Application number: **07739020.1**

(22) Date of filing: **19.03.2007**

(51) Int Cl.:
*C30B 29/38* (2006.01)          *C03B 23/08* (2006.01)
*H01L 21/205* (2006.01)

(86) International application number:
**PCT/JP2007/055577**

(87) International publication number:
**WO 2007/119433 (25.10.2007 Gazette 2007/43)**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK RS**

(30) Priority: **20.03.2006 JP 2006076733**
**28.08.2006 JP 2006231274**
**12.12.2006 JP 2006334612**

(71) Applicants:
• **KANAGAWA ACADEMY OF SCIENCE AND TECHNOLOGY**
**Kawasaki-shi,**
**Kanagawa-ken 213-0012 (JP)**
• **The University of Tokyo**
**Bunkyo-Ku,**
**Tokyo 113-0033 (JP)**

• **Mitsubishi Chemical Corporation**
**Minato-ku**
**Tokyo 108-0014 (JP)**

(72) Inventors:
• **FUJIOKA, Hiroshi**
**Kawasaki-shi, Kanagawa 2130012 (JP)**
• **KOBAYASHI, Atsushi**
**Bunkyo-ku, Tokyo 1130033 (JP)**
• **HORIE, Hideyoshi**
**Ushiku-shi, Ibaraki 3001295 (JP)**
• **AMANAI, Hidetaka**
**Ushiku-shi, Ibaraki 3001295 (JP)**
• **NAGAO, Satoru**
**Ushiku-shi, Ibaraki 3001295 (JP)**

(74) Representative: **Luderschmidt, Wolfgang**
**John-F.-Kennedy-Strasse 4**
**65189 Wiesbaden (DE)**

(54) **GROUP III-V NITRIDE LAYER AND METHOD FOR PRODUCING THE SAME**

(57)     There is disclosed a hexagonal Group III-V nitride layer exhibiting high quality crystallinity capable of improving the properties of a semiconductor device such as a light emitting element. This nitride layer is a Group III-V nitride layer belonging to hexagonal crystal formed by growth on a substrate having a different lattice constant, which has a growth-plane orientation of {1-100} and in which a full width at half maximum $b_1$ of angle dependence of X-ray diffraction intensity in a {1-210} plane perpendicular to the growth-plane upon X ray incident angle from a direction parallel to the growth-plane satisfies the condition of $0.01° \leq b_1 \leq 0.5°$, or the full width at half maximum $b_2$ of angle dependence of X-ray diffraction intensity in a {0001} plane upon X-ray incident angle from a direction parallel to the growth-plane satisfies the condition of $0.01° \leq b_2 \leq 0.5°$.

Fig. 3

**Description**

Technical Field

The present invention relates to a Group III-V nitride layer, more particularly a Group III-V nitride layer exhibiting good crystallinity which can be used in, for example, a light-emitting device.

Background Art

With intense research and developmental attempts for Group III-V nitride semiconductor represented by $In_x$-$Al_yGa_{(1-x-y)}N$ ($0 \leq x \leq 1$, $0 \leq y \leq 1$, $0 \leq x + y \leq 1$), there has been exponentially improved a luminous efficiency of a light-emitting device such as a light-emitting diode and a laser diode using such a semiconductor.

$In_xAl_yGa_{(1-x-y)}N$ represented by GaN belongs to hexagonal crystal and is commonly formed on c-plane of a substrate such as sapphire by epitaxial growth. In a structure where on a GaN layer is deposited a quantum well layer made of $In_xGa_{(1-x)}N$($0 < x \leq 1$) mixed crystal as an active layer, it is used or highly expected as a blue and a green LEDs or a layer configuration for a next-generation DVD laser, but due to difference of a lattice constant with the GaN layer, a compressive strain is applied to the quantum well layer.

A hexagonal Group III-V nitride semiconductor has spontaneous polarization because it is a polarizable material having a c-axis as a polarization axis. Furthermore, additionally, a strong internal electric field is induced in the strained quantum well on the c-plane due to piezoelectric polarization, and therefore, an electron and a hole are spatially separated within one quantum well layer. In other words, for example, an InGaN layer on a GaN layer grown on c-plane has an intrinsic problem of a low probability of radiative recombination of electron and hole. Furthermore, it has another problem that an emission wavelength shifts toward longer wavelengths due to piezoelectric polarization, which makes it difficult to obtain a shorter emission wavelength. Furthermore, it has been observed that during driving an element, an emission wavelength varies depending on an injection current, that is, the wavelength is shorter at a lower injection current while being longer at a higher injection current, leading to difficulty in wavelength control. These phenomena are known as quantum confined stark effect (QCSE), and its influence is inevitable in a hexagonal Group III-V nitride semiconductor when a strained quantum well layer such as InGaN is coherently grown on c-plane of GaN grown on c-plane of, for example, a sapphire substrate, which has been a significant problem in practical use.

Meanwhile, since a-plane and m-plane in GaN are nonpolar, compressive strain does not generate a polarization electric field in an InGaN layer formed on it. It is, therefore, believed that quantum confined stark effect, which causes reduction in a luminous efficiency and wavelength shift due to increase in an injection current, can be avoided.

However, a hexagonal Group III-V nitride crystal cannot be epitaxially grown on a-plane or m-plane, and a threading dislocation density and a stacking fault density are so high that a high-quality hexagonal system III-V nitride semiconductor laminated structure cannot be obtained. For example, Non-Patent document 1 {the 66th Annual Meeting of Japan Society of Applied Physics, Conference Proceedings (Autumn, 2005) 11p-N-4} describes "its growth on nonpolar m-plane is difficult", and employs a special method where a GaN substrate having c-plane as a principal surface is processed into a stripe shape and on m-plane in its side, then crystal is grown, .

Furthermore, Non-Patent document 2 {Appl. Phys. Lett., Vol.82, No. 11 (17 March 2003), pp.1793-1795} has described that on a ZnO m-plane (0-100) substrate, a GaN layer was grown by plasma assisted MBE (molecular-beam epitaxy), but as it describes "slate-like", a substrate formed shows considerable surface asperity without forming a single crystal layer.

Patent document 1 {Japanese Laid-open Patent Publication No. 2005-75651} and Non-Patent document 3 {Journal of Crystal Growth 275 (2005) pp.e1143-e1148} have described attempts for GaN growth on an a-plane ZnO substrate. Patent document 1 has described that a ZnO substrate having an a-plane (11-20) plane was heated at 1150 °C to form a stripe texture and then GaN was formed by MBE at 650 °C and X-ray diffraction indicated formation of a GaN film having (11-20) plane. There are, however, no descriptions in terms of crystallinity quality. Non-Patent document 5 in which experiments equivalent to those in Patent document 1 are conducted, has described that a GaN epitaxial layer cannot be directly deposited on an a-plane and m-plane ZnO substrate and a directly grown film shows poor crystallinity.

Non-Patent document 4 {Journal of Crystal Growth 193 (1998) pp.127-132} has reported that a GaN(1-100) can be grown on $\gamma$-$LiAlO_2$, resulting in relatively better crystallinity. However, since Li easily diffuse into a semiconductor layer and influences the electric properties, $LiAlO_2$ cannot be used as a growth substrate for manufacturing an actual light-emitting device.

Non-Patent document 5 {Japanese Journal of Applied Physics, Vol.43, No.1A/B, 2004, pp L53-L55} has disclosed that GaN is grown on planarized ZnO c-plane (000-1) at room temperature by pulse laser deposition (PLD: pulsed laser deposition), but has no descriptions about growth on a nonpolar plane such as m-plane.

Non-Patent document 6 {Applied Physics Letters, vol. 83, No. 25, 2003, pp.5208-5210} has reported that an AlN layer having an extremely narrow full width at half maximum of X-ray diffraction can be formed on a 4H-SiC substrate by plasma assisted MBE. However, once C enters a Group III-V semiconductor layer, it may become amphoteric impurity and may adversely affect conductivity control of the layer, and furthermore, a layer with a higher C concentration may generally deteriorate reliability of a light-emitting device, so that it is not desirable to use SiC as a substrate for growth for manufacturing an actual light-emitting device.

Patent document 1: Japanese Laid-open Patent Publication No. 2005-75651
Non-Patent document 1: the 66th Annual Meeting of Japan Society of Applied Physics, Conference Proceedings (Autumn, 2005) 11p-N-4
Non-Patent document 2: Appl. Phys. Lett., Vol.82, No.11 (17 March 2003), pp.1793-1795
Non-Patent document 3: Journal of Crystal Growth 275 (2005) pp.e1143-e1148
Non-Patent document 4: Journal of Crystal Growth 193 (1998) pp.127-132
Non-Patent document 5: Japanese Journal of Applied Physics, Vol.43, No.1A/B, 2004, pp L53-L55
Non-Patent document 6: Applied Physics Letters, vol. 83, No. 25, 2003, pp.5208-5210

Disclosure of the Invention

Subject to be solved by the Invention

As described above, in terms of growth in a nonpolar plane such as m-plane and a-plane of a hexagonal Group III-V nitride, there have been obtained no crystals having usable property. In addition, there have been known no suitable process for such crystal growth.

An objective of the present invention is to provide a hexagonal Group III-V nitride layer having high quality crystallinity capable of improving the properties of a semiconductor device such as a light emitting element.

In particular, an objective of the present invention is to provide a hexagonal Group III-V nitride layer having high quality, in which nonpolar plane can be utilized for avoiding QCSE, and which is suitable for a light-emitting device.

An objective of another aspect of the present invention is to provide a process for manufacturing a hexagonal Group III-V nitride layer having high quality crystallinity.

Means to solve the Subject

The present invention relates to a Group III-V nitride layer belonging to hexagonal crystal formed by growing on a substrate having a different lattice constant, with the proviso that a substrate containing either Li or C as a principal constituent element is excluded, wherein the Group III-V nitride layer satisfies at least one of the following conditions (i) to (iv).

(i) A growth-plane is a plane perpendicular to {0001} (hereinafter, referred to as a "nonpolar plane") and a full width at half maximum $b_1$ of angle dependence of X-ray diffraction intensity in a plane perpendicular to the growth-plane and parallel to c-axis [0001], upon X ray incident angle from a direction parallel to the growth-plane, satisfies the condition of $0.01° \le b_1 \le 0.5°$.

(ii) A growth-plane is a nonpolar plane and a full width at half maximum $b_2$ of angle dependence of a X-ray diffraction intensity in {0001}plane, upon X-ray incident angle from a direction parallel to the growth-plane, satisfies the condition of $0.01° \le b_2 \le 0.5°$.

(iii) A growth-plane is a nonpolar plane, and when a diffraction plane is {1-100}plane or {11-20}plane which forms an angle of 60° or more and less than 90° with the growth-plane, a full width at half maximum $b_3$ of angle dependence of X-ray diffraction intensity in the diffraction plane, upon X-ray incident angle from a direction parallel to a plane perpendicular to the diffraction plane and parallel to c-axis [0001], satisfies the condition of $0.01° \le b_3 \le 0.5°$.

(iv) A growth-plane is a nonpolar plane and when, assuming that the growth-plane orientation is represented by {ijk0} a diffraction plane is {ijk2}plane tilted from the growth-plane only to [0001] and [000-1] directions, a full width at half maximum $b_4$ of angle dependence of X-ray diffraction intensity in the diffraction plane, upon X-ray incident angle from a direction parallel to a plane formed by tilting {0001} plane by an angle equal to a tilt angle from the growth-plane to the diffraction plane in the same direction, satisfies the condition of $0.01° \le b_4 \le 0.5°$.

According to another aspect of the present invention, there is provided a Group III-V nitride layer belonging to hexagonal crystal formed by growing on a substrate having a different lattice constant, with the proviso that a substrate containing either Li or C as a principal constituent element is excluded, wherein the growth-plane is a nonpolar plane and a full width at half maximum $a_1$ of angle dependence of X-ray diffraction intensity in the growth-plane, upon X-ray incident angle from a direction parallel to a plane perpendicular to the growth-plane and parallel to c-axis [0001], satisfies the condition of $0.01° \le a_1 \le 0.25°$.

According to another aspect of the present invention, there is provided a process for growing a Group III-V nitride layer belonging to hexagonal crystal on a substrate having a different lattice constant, with the proviso that a substrate containing Li as a principal constituent element is excluded,
the process comprising steps of:

(a) providing a substrate having, as a principal surface, a hexagonal nonpolar plane or a plane having a lattice structure identical to that of the hexagonal nonpolar plane,
(b) growing the Group III-V nitride layer on the principal surface of the substrate at least in two steps, comprising
(b-1) a first sub-growing step of growing a first layer on the principal surface of the substrate at a growth temperature of lower than 500 °C while maintaining a single crystal structure on the growth-plane, and
(b-2) a second sub-growing step of growing a second layer on the first layer at a growth temperature of 400 °C or higher and higher than the growth temperature in the first sub-growing step.

According to another aspect of the present invention, there is provided a process for growing a Group III-V nitride layer belonging to hexagonal crystal on a substrate having a different lattice constant, with the proviso that a substrate containing Li as a principal constituent element is excluded,
the process comprising growing steps of:

(a) providing a substrate having a hexagonal nonpolar plane or a plane having a lattice structure identical to that of the hexagonal nonpolar plane,
(b) growing the Group III-V nitride layer on the principal surface of the substrate at least in two steps, comprising
(b-1) a first sub-growing step of growing a first layer on the principal surface of the substrate at a growth temperature of lower than 500 °C and a growth rate of more than 10 nm/hr and less than 300 nm/hr, and
(b-2) a second sub-growing step of growing a second layer on the first layer at a growth temperature of 400 °C or higher and higher than the growth temperature in the first sub-growing step.

According to another aspect of the present invention, there is provided a process for growing a Group III-V nitride layer belonging to hexagonal crystal on a substrate having a different lattice constant, with the proviso that a substrate containing Li as a principal constituent element is excluded,
the process comprising growing steps of:

(a) providing a substrate having a hexagonal nonpolar plane or a plane having a lattice structure identical to that of the hexagonal nonpolar plane,
(b) growing the Group III-V nitride layer on the principal surface of the substrate at least in two steps, comprising
(b-1) a first sub-growing step of growing a first layer on the principal surface of the substrate at a growth temperature of lower than 500 °C while intermittently supplying a Group III element with a supply stop period in the range of 0.001 sec to 10 sec, and
(b-2) a second sub-growing step of growing a second layer on the first layer at a growth temperature of 400 °C or higher and higher than the growth temperature in the first sub-growing step.

According to another aspect of the present invention, there is provided a process for growing a Group III-V nitride layer belonging to hexagonal crystal on a substrate having a different lattice constant, with the proviso that a substrate containing Li as a principal constituent element is excluded,
the process comprising the growing steps of:

(a) providing a substrate having a hexagonal nonpolar plane or a plane having a lattice structure identical to that of the hexagonal nonpolar plane,
(b) growing the Group III-V nitride layer on the principal surface of the substrate at least in two steps, comprising
(b-1) a first sub-growing step of growing a first layer on the principal surface of the substrate at a growth temperature of lower than 500 °C and a growth rate of more than 10 nm/hr and less than 300 nm/hr while intermittently supplying a Group III element with a supply stop period in the range of 0.001 sec to 10 sec, and
(b-2) a second sub-growing step of growing a second layer on the first layer at a growth temperature of 400 °C or higher and higher than the growth temperature in the first sub-growing step.

Effect of the Invention

According to the present invention, there can be provided a hexagonal Group III-V nitride layer having high quality crystallinity capable of improving the properties of a semiconductor device such as a light emitting element. In particular, according to one aspect of the present invention, there can be provided a hexagonal Group III-V nitride layer having high quality whose nonpolar plane can be utilized for avoiding QCSE, and therefore suitable for a light-emitting device. Furthermore, according to another aspect of the present invention, there can be provided a process for manufacturing a hexagonal Group III-V nitride layer exhibiting high quality crystallinity.

BRIEF DESCRIPTION OF THE DRAWINGS

FIG. 1 is a figure for illustrating Miller's index of hexagonal crystal.

FIG. 2 illustrates a method for determining X-ray rocking curve (XRC).

FIG. 3 illustrates an example of a Group III-V nitride layer according to the present invention.

FIG. 4 is a flow chart illustrating an example of a process for manufacturing a Group III-V nitride layer.

FIG. 5 illustrates a configuration of a PLD apparatus.

FIG. 6 is a cross-sectional TEM image from the [11-20] direction of a GaN layer grown under the growth conditions as described for Example A-6.

FIG. 7A is an atomic force microscopy image of a ZnO substrate surface after planarization (pretreated at 1250 °C for 3.5 hrs).

FIG. 7B is an atomic force microscopy image of a ZnO substrate surface before planarization.

FIG. 8A is a RHEED image of a ZnO substrate surface before initiating layer growth in the first sub-growing step.

FIG. 8B is a RHEED image of a film surface in the course of growth (after 2 min) in the first sub-growing step.

FIG. 8C is a RHEED image of a film surface in the course of growth (after 10 min) in the first sub-growing step.

FIG. 9A is a RHEED image and its schematic view of a film surface when a first layer is grown to 10 nm at 500 °C in the first sub-growing step in Comparative Example A-1.

FIG. 9B is a RHEED image and its schematic view of a film surface when a first layer is grown to 40 nm in the first sub-growing step in Comparative Example A-4.

FIG. 10 shows the photoluminescence measurement results for a GaN layer grown in Example A-6.

FIG. 11 shows an atomic force microscopy image of an a-plane ZnO substrate surface after chemical mechanical polishing (a side length of the image is 5 $\mu$m).

FIG. 12 shows an atomic force microscopy image of an a-plane ZnO substrate surface after annealing at 700 °C for 10 hours (a side length of the image is 5 $\mu$m).

FIG. 13 shows an atomic force microscopy image of an a-plane ZnO substrate surface after annealing at 850 °C for 10 hours (a side length of the image is 5 $\mu$m).

FIG. 14 shows an atomic force microscopy image of an a-plane ZnO substrate surface after annealing at 950 °C for 10 hours (a side length of the image is 5 $\mu$m).

FIG. 15 shows an atomic force microscopy image of an a-plane ZnO substrate surface after annealing at 1150 °C for 6 hours (a side length of the image is 5 $\mu$m).

FIG. 16 shows a RHEED image after depositing a GaN layer, the first layer, as the first sub-growing step in Example B-1.

In the drawings, the symbols have the following meanings; 10: laminated structure, 11: ZnO substrate, 12: Group III-V nitride layer (GaN layer), 13: GaN low-temperature deposition layer, 14: GaN high-temperature deposition layer, 30: PLD apparatus, 31: chamber, 31a: window, 32: target, 33: KrF excimer laser, 34: lens, 35: gas supply unit, 36: nitrogen radical source, 36a: adjusting valve, 37: pressure valve, 38: rotary pump, and 39: rotation axis.

DETAILED DESCRIPTION OF THE INVENTION

Description of symbols such as a plane orientation

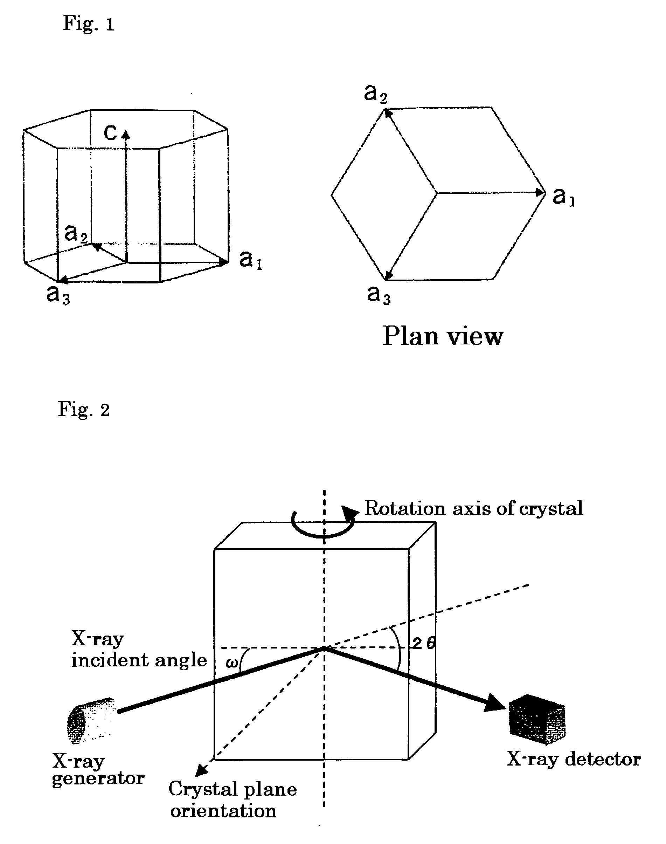

First, there will be described a representation form of a crystalline plane orientation and an axial direction. A crystalline plane orientation and an axial direction are represented by Miller's indexes. Although it is possible to use three indexes for hexagonal crystal, a four-index method is herein used. There will be described Miller's indexes in hexagonal crystal with reference to FIG. 1. It is represented using three indexes ($a_1$, $a_2$, $a_3$ directions) in a regular hexagonal plane and one index in a direction perpendicular to the hexagonal plane called c-axis (c-direction). Here, $a_1$, $a_2$ and $a_3$ axes form 120° with each other and have an equal length. Then, c-axis orthogonal to these has a length different from that of a-axis group. An orientation in a regular hexagonal plane can be completely assigned by only two of $a_1$, $a_2$ and $a_3$ axes, but one more axis is introduced for maintaining symmetry. They are, therefore, not independent from each other. One parallel plane group is expressed as (ijkl), which represents that distances from the origin to the points where the first plane from the origin crosses $a_1$, $a_2$, $a_3$ and c-axes are $a_1/i$, $a_2/j$, $a_3/k$ and c/l, respectively, wherein "l" is "el". Since $a_1$, $a_2$ and $a_3$ axes are a redundant coordinate system contained within a regular hexagonal plane, i, j and k are mutually dependent and thus the equation i+j+k=0 is always true. Among these four indexes, i, j and k have rotation symmetry while I is independent.

Herein, a plane orientation and a crystal orientation are expressed as follows in accordance with a general notational system in crystallography.

An individual plane orientation is expressed in round parentheses ( ) while an equivalent plane orientation set is expressed in curly brackets { }. An equivalent plane orientation refers to a plane orientation attainable by any symmetry operation allowed in the crystal system. For example, {1-100} collectively expresses any plane equivalent to (1-100), and expresses all of 6 planes including (10-10), (01-10), (-1100), (-1010) and (0-110) attainable by rotating operation of (1-100) using c-axis as a rotation axis.

A crystal orientation (crystal axis) is expressed as a set of indexes identical to those of a plane perpendicular to it. An individual crystal orientation is expressed in square brackets [ ] while a set of equivalent orientations is expressed in angle brackets < >.

As generally used, {1-100} is sometimes called m-plane and <1-100> is sometimes called m-axis. A typical hexagonal system plane orientation can be expressed as, for example, c-plane (0001), a-plane (11-20), m-plane(1-100) or r-plane (10-12).

Since a hexagonal system Group III-V nitride layer has a crystal structure where in a c-axis <0001> direction, Ga layers and N layers are alternately stacked, any plane perpendicular to c-plane {0001}plane is a nonpolar plane. Specifically, when a growth-plane orientation is expressed as {ijkl}, it is a plane orientation (except {0000}) satisfying the condition of 1 = 0. Examples of typical planes include m-plane{1-100}plane, a-plane{11-20}plane, {12-30}plane and {13-40}plane.

Description of X-ray diffraction

A nitride crystal grown by heteroepitaxial growth with lattice mismatch has a mosaic structure, where column-shaped crystal grains having crystal orientations slightly different from each other gather to form a film. This mosaic structure is a reflection of crystal defects which are observed in atomic level such as dislocations and point defects. For Column-shaped crystal grains containing less dislocations in its inside are bonded via a crystal grain boundary, and dislocations exist at the grain boundary. Here, X-ray diffraction is widely used as a method for macroscopically evaluating a mosaic structure. A crystal having a mosaic structure has regions having slightly different plane orientations in its inside. In such a crystal, reciprocal lattice points spreads on concentric sphere centering the origin in a reciprocal space. Therefore, this spreading on concentric sphere can be determined by X-ray diffraction to evaluate the extent of fluctuation of a plane orientation.

To that end, while an angle ($2\theta$) between incident X-ray and a detector is fixed at a diffraction peak position, a X-ray incident angle ($\omega$) between a sample crystal and incident X-ray is scanned around the diffraction conditions. Thus, as shown in FIG. 2, spreading of spherical reciprocal lattice points centering the origin in a reciprocal space can be evaluated as a diffraction intensity distribution. Such measurement is called X-ray rocking curve (XRC) or $\omega$ mode (scan) measurement, in which a width of the measured diffraction spectrum reflects the extent of fluctuation of a plane orientation and a full width at half maximum (half bandwidth) is used as a quantitative index. In terms of a full width at half maximum thus determined, a sample crystal having a smaller value is a high quality and crystallographically better crystal.

A mosaic structure in a thin film crystal can be divided, in relation to growth direction, into a "tilt", that is, fluctuation of a crystal axis in growth direction and a "twist", that is, crystal rotation using a crystal axis in growth direction as a rotation axis. By appropriately selecting a diffraction plane and a crystal rotation axis, a tilt and a twist can be separated in X-ray rocking curve measurement. When forming a nitride layer on a substrate having a different crystal structure or lattice constant, a tilt and a twist are not necessarily nearly equal. Depending on the type of a substrate, a growing method of a nitride layer and growth conditions, a tilt may be considerably small while a twist may be considerably large. Such a nitride layer exhibits significantly poor luminescence properties or electric properties, and thus a practically usable light-emitting device cannot be prepared using such a nitride layer. When using a nitride layer as a light-emitting device, it is desirable that both tilt and twist are small.

A tilt and a twist obtained by using X-ray rocking curve measurement can be expressed by any of multiple ways, by selecting a diffraction plane and a X-ray incident direction.

Description of $b_1$ to $b_4$, $a_1$ and $a_2$ defined herein

Herein, $b_1$ refers to a full width at half maximum of angle dependence of X-ray diffraction intensity in a plane perpendicular to a growth-plane and parallel to c-axis [0001], upon X ray incident angle from a direction parallel to the growth-plane, where the growth-plane is a nonpolar plane. Specifically, when a growth-plane orientation is m-plane {1-100}, it represents a full width at half maximum of angle dependence of X-ray diffraction intensity in a-plane{11-20} perpendicular to the growth-plane upon X-ray incident angle from a direction parallel to the growth-plane. In other words, X-ray parallel to m-plane is introduced to a-plane perpendicular to m-plane, and angle dependence of a X-ray diffraction intensity on the X-ray incident angle ($\omega$) is measured while rotating a crystal by using m-axis <1-100> which is a crystal axis in a growth direction as a rotation axis, and, thus, a full width at half maximum $b_1$ is determined. A full width at half maximum $b_1$ of angle dependence thus obtained quantitatively represents a twist using the crystal axis in growth direction (m-axis) as a rotation axis in the mosaic structure of the crystal. When the growth-plane orientation is a-plane{11-20}, {1-100}plane perpendicular to the growth-plane is selected as a diffraction plane, and $b_1$ represents a full width at half maximum of angle dependence of a X-ray diffraction intensity in the diffraction plane upon X-ray incident angle from a direction parallel to the growth-plane.

Herein, $b_2$ refers to a full width at half maximum $b_2$ of angle dependence of a X-ray diffraction intensity in {0001} plane upon X-ray incident angle from a direction parallel to the growth-plane where the growth-plane is a nonpolar plane. Specifically, when a growth-plane orientation is m-plane{1-100}, it represents a full width at half maximum of angle dependence of X-ray diffraction intensity in c-plane {0001} upon X-ray incident angle from a direction parallel to the growth-plane. Here, X-ray parallel to m-plane is introduced to c-plane perpendicular to m-plane and angle dependence of a X-ray diffraction intensity on the X-ray incident angle ($\omega$) is measured while rotating a crystal using m-axis <1-100> which is a crystal axis in a growth direction as a rotation axis, and, thus, a full width at half maximum $b_2$ is determined. A full width at half maximum $b_2$ of angle dependence thus obtained quantitatively represents a twist using the crystal axis in growth direction (m-axis) as a rotation axis in the mosaic structure of the crystal. When the growth-plane orientation is a-plane{11-20}, it represents a full width at half maximum of angle dependence of a X-ray diffraction intensity in c-plane {0001} upon X-ray incident angle from a direction parallel to the growth-plane.

Herein, $b_3$ refers to a full width at half maximum $b_3$ of angle dependence of X-ray diffraction intensity in the diffraction plane upon X-ray incident angle from a direction parallel to a plane perpendicular to the diffraction plane and parallel to c-axis [0001] when a diffraction plane is {1-100}plane or {11-20}plane which forms an angle of 60° or more and less than 90° with the growth-plane, where the growth-plane is a nonpolar plane. Specifically, when the growth-plane orientation is m-plane{1-100}, it represents a full width at half maximum of angle dependence of X-ray diffraction intensity in m-plane{1-100} other than the growth-plane and planes parallel to the growth-plane upon X-ray incident angle from a direction parallel to a-plane{1-210} perpendicular to the diffraction plane. Here, X-ray is introduced to m-plane{1-100} other than the growth-plane from a direction parallel to a-plane{1-210} perpendicular to the diffraction plane and the crystal is rotated using a crystal axis <1-210> perpendicular to the a-plane{1-210} as a rotation axis to determine angle ($\omega$) dependence of the sample crystal and the incident X-ray and thus to determine a full width at half maximum $b_3$. The full width at half maximum $b_3$ of angle dependence thus obtained represents the mosaic structure of the crystal, containing information of both twist and tilt. When the growth-plane orientation is a-plane{11-20}, {11-20} other than the growth-plane and planes parallel to it is selected as a diffraction plane; and $b_3$ represents a full width at half maximum of angle dependence of X-ray diffraction intensity in the diffraction plane upon X-ray incident angle from a direction parallel to m-plane{10-10}plane perpendicular to the diffraction plane.

Herein, $b_4$ refers to a full width at half maximum $b_4$ of angle dependence of X-ray diffraction intensity in the diffraction plane upon X-ray incident angle from a direction parallel to a plane formed by tilting {0001}plane by an angle equal to a tilt angle from the growth-plane to the diffraction plane in the same direction, wherein, assuming that the growth-plane orientation is represented by {ijk0} a diffraction plane is {ijk2}plane tilted from the growth-plane only to [0001] and [000-1] directions, where a growth-plane is a nonpolar plane. Specifically, when the growth-plane orientation is m-plane{1-100} and a measurement plane is r-plane {10-12} tilting from the growth-plane only to c-axis [0001] and c-axis [000-1] direction, $b_4$ represents a full width at half maximum of angle dependence of X-ray diffraction intensity in the measurement plane upon X-ray incident angle from a direction parallel to a plane obtained by tilting c-plane {0001} by an angle equal to a tilt angle from the growth-plane to the measurement plane in the same direction. The r-plane {10-12}, which is the measurement plane, is a plane tilting by 47.2° to m-plane, which is the growth-plane, and the full width at half maximum $b_4$ of angle dependence obtained by the measurement represents the mosaic structure of the crystal, containing information of both twist and tilt. When the growth-plane orientation is a-plane{11-20}, the measurement plane is {11-22}plane.

Herein, $a_1$ refers to a full width at half maximum of angle dependence of X-ray diffraction intensity of a growth-plane upon X-ray incident angle from a direction parallel to a plane perpendicular to the growth-plane and parallel to c-axis [0001], where the growth-plane is a nonpolar plane. This quantitatively represents a tilt of the growth-plane in a direction parallel to c-axis [0001]. When the growth-plane is m-plane{1-100}, it represents a full width at half maximum of angle dependence of X-ray diffraction intensity of m-plane{1-100} upon X-ray incident angle from a direction parallel to a-plane{1-210} perpendicular to the m-plane{1-100}. When the growth-plane is a-plane{11-20}, it represents a full width at half maximum of angle dependence of X-ray diffraction intensity of the growth-plane upon X-ray incident angle from a direction parallel to m-plane{1-100} perpendicular to the a-plane{11-20}.

Herein, $a_2$ refers to a full width at half maximum of angle dependence of X-ray diffraction intensity of a growth-plane upon X-ray incident angle from a direction perpendicular to c-axis [0001], where a growth-plane is a nonpolar plane. When the growth-plane is either m-plane{1-100} or a-plane{11-20}, it quantitatively represents a tilt of each growth-plane in a direction perpendicular to c-axis [0001].

Description of embodiments of the present invention

The present invention relates to a Group III-V nitride layer belonging to hexagonal crystal formed by growth on a substrate having a different lattice constant. In the first aspect of the present invention, a growth-plane orientation is a nonpolar plane and its crystallinity satisfies any of the following conditions.

$$\text{Equation 1: } 0.01° \leq b_1 \leq 0.5°$$

$$\text{Equation 2: } 0.01° \leq b_2 \leq 0.5°$$

$$\text{Equation 3: } 0.01° \leq b_3 \leq 0.5°$$

$$\text{Equation 4: } 0.01° \leq b_4 \leq 0.5°$$

As described above, $b_1$ and $b_2$ represent a twist component in a mosaic structure of a crystal while $b_3$ and $b_4$ represent a combination of a twist component and a tilt component in a mosaic structure of a crystal. Therefore, $b_1$ to $b_4$ are expressions of twist data of a mosaic structure of crystal by different styles. Depending on the condition of the Group III-V nitride layer, it may be difficult to determine all of $b_1$ to $b_4$, but a crystal satisfying at least one of the conditions of equations 1 to 4 has excellent crystallinity with a small twist.

Equations 1 to 4 means that a mosaic structure of a crystal is very small, indicating a substantially high quality Group III-V nitride layer. In particular, a twist component in a mosaic structure of a crystal is an important index having an influence on device properties in manufacturing a light-emitting device.

On this Group III-V nitride layer, a light-emitting device structure having an active layer can be epitaxially grown to provide a light-emitting diode or semiconductor laser with a low dislocation density, high quality crystallinity and a high luminous efficiency. Furthermore, when the active layer is a strained quantum well, the quantum well can be formed in a nonpolar plane such as m-plane to eliminate reduction in a light-emission probability due to quantum confined stark effect. In addition, owing to excellent crystal quality, an excellent luminous efficiency unattainable by a conventional strained quantum well formed in c-plane is achieved and the problem of wavelength shift due to increase in an injection current is alleviated.

More preferably, the Group III-V nitride layer satisfies at least one of the following conditions.

$$\text{Equation 1-2: } 0.01° \leq b_1 \leq 0.2°$$

$$\text{Equation 2-2: } 0.01° \leq b_2 \leq 0.2°$$

$$\text{Equation 3-2: } 0.01° \leq b_3 \leq 0.2°$$

$$\text{Equation 4-2: } 0.01° \leq b_4 \leq 0.2°$$

Most preferably, the Group III-V nitride layer satisfies at least one of the following conditions.

$$\text{Equation 1-3: } 0.01° \leq b_1 \leq 0.15°$$

$$\text{Equation 2-3: } 0.01° \leq b_2 \leq 0.15°$$

$$\text{Equation 3-3: } 0.01° \leq b_3 \leq 0.15°$$

$$\text{Equation 4-3: } 0.01° \leq b_4 \leq 0.15°$$

In a second aspect of the present invention, crystallinity of a Group III-V nitride layer satisfies the following condition.

$$\text{Equation 5: } 0.01° \leq a_1 \leq 0.25°$$

As described above, $a_1$ represents a tilt component in a mosaic structure of a crystal in a nonpolar growth-plane, and equation 5 means that a mosaic structure of a crystal is very small, indicating a high quality crystal. Further preferably, the Group III-V nitride layer satisfies the following equation.

$$\text{Equation 5-2: } 0.01° \leq a_1 \leq 0.15°.$$

In the first and the second aspects of the present invention, it is preferable that the following condition is met.

$$\text{Equation 6: } 0.05° \leq a_2 \leq 0.5°.$$

As described above, $a_2$ also represents a tilt component in a mosaic structure of a crystal in a nonpolar growth-plane, and equation 6 means that a mosaic structure of a crystal is very small, indicating a high quality crystal.

A light-emitting diode or semiconductor laser with a low dislocation density, high-quality crystallinity and a high luminous efficiency can be realized by epitaxial growth of a light-emitting device structure having an active layer on a Group III-V nitride layer in which a growth-plane is a nonpolar plane such as m-plane. Furthermore, when the active layer is a strained quantum well, the quantum well can be formed in a nonpolar plane such as m-plane; which eliminates reduction in a light-emission probability due to quantum confined stark effect, and, owing to excellent crystal quality, achieves an excellent luminous efficiency unattainable by a conventional strained quantum well formed in c-plane and alleviates the problem of wavelength shift due to increase in an injection current.

As described above, a Group III-V nitride layer having the specific crystallinity as defined in the present invention has not been present in the past; more specifically, it is a novel layer manufactured for the first time by the process described below.

There are no particular restrictions to a growth-plane in a Group III-V nitride layer of the present invention as long as it is a nonpolar plane, but it is preferably {ijk0} plane wherein i, j and k are independently an integer having the absolute value of 5 or less, provided i, j and k are not simultaneously 0, wherein "0" in {ijk0} is "zero" . More preferably it is a {ijk0}plane wherein i, j and k are independently an integer having an absolute value of 3 or less. Examples may include m-plane {1-100}plane, a-plane{11-20}plane, {12-30}plane and {13-40}, preferably m-plane{1-100}plane and a-plane{11-20}plane, most preferably m-plane.

A Group III-V nitride layer according to the present invention contains Group III-V elements such that a hexagonal crystal is formed, preferably it contains Ga and N as constituent elements, and further preferably it is a Group III-V nitride represented by $In_xAl_yGa_{1-x-y}N$ wherein x and y are numbers satisfying the conditions of $0 \leq x \leq 1$, $0 \leq y \leq 1$ and $0 \leq x+y \leq$

EP 2 009 148 A1

1. In one embodiment of the present invention, a GaN layer is contained. On the GaN layer can be easily grown a crystal such as GaN, InGaN, AlGaN and AlInGaN which exhibit lattice matching or have similar lattice constants. In other words, in a preferable embodiment of the present invention, a Group III-V nitride layer has at least two layers; for example, as a first layer can be formed a GaN layer, on which as a second layer, a Group III-V nitride layer selected from GaN, InN, AlN, InGaN, AlGaN, AlInN and AlInGaN can be grown. However, it is also possible to grow, as the first layer, a Group III-V nitride layer selected from InN, AlN, InGaN, AlGaN, AlInN and AlInGaN and to grow, as the second layer, a Group III-V nitride layer selected from GaN, InN, AlN, InGaN, AlGaN, AlInN and AlInGaN over the first layer.

A thickness of a Group III-V nitride layer is preferably 5 nm or more and 10000 nm or less, more preferably 5 nm or more and 500 nm or less, further preferably 10 nm or more and 300 nm or less. Generally, in a nitride crystal on a heterogeneous substrate, as a growth film thickness increases, a threading dislocation density is reduced to give a high quality crystal having a narrow full width at half maximum in a X-ray rocking curve. Although the mechanism of this phenomenon is not clearly understood, it would be caused by variation of a direction of a threading dislocation along with a film thickness, which results in disappearance of dislocations by their interaction, formation of a dislocation loop and some dislocations reaching the end of the crystal. However, increase of a growth film thickness for reducing a dislocation density may lead to increase in a material cost and restrictions to a manufacturing throughput.

A Group III-V nitride layer of the present invention is a high-quality nitride crystal having a narrow full width at half maximum in a X-ray rocking curve even when it is a crystal film having an extremely small thickness of 300 nm or less. This means that crystallinity is considerably high from a growth initiation plane (an interface with a substrate). In a conventional nitride layer grown on a heterogeneous substrate, crystallinity is not satisfactory within, for example, a range of 50 nm (or 100 nm) from a growth initiation plane even when crystallinity is satisfactory in a thick film. In contrast, in the present invention, crystallinity within a range of, for example, 50 nm from a growth initiation plane satisfies the predetermined conditions for $b_1$ to $b_4$ or $a_1$ defined in the present invention, wherein, the reference distance 50 nm may be 30 nm or 100 nm, and when a thickness is smaller than a reference distance, the distance is the film thickness. As described in a manufacturing process below, such a layer would be formed by a growing process where, surprisingly, growth of a single crystal initiates immediately from a substrate plane having a different lattice constant.

In a preferred embodiment of the present invention, a Group III-V nitride layer has at least two layers, wherein a first layer is formed at a growth temperature of less than 500 °C and growth is initiated immediately on a substrate. A second layer is a layer formed on the first layer at a growth temperature of 400 °C or higher and higher than a growth temperature of the first layer. Further preferably, the first layer is formed at a growth temperature of 450 °C or lower while the second layer is formed at a growth temperature of 400 to 1300 °C. A growth temperature of the first layer may be in principle less than 0 °C such as 77 K, but it is generally 0 °C or higher, for example 10 °C or higher, practically preferably room temperature (20 to 30 °C) or higher. In one embodiment of the present invention, it is selected from a range of room temperature to 450 °C, and in another aspect, may be selected from a range of 100 °C to 450 °C. Alternatively, it may be selected from a range of 250 °C to 400 °C. Preferably, the first layer is formed to a thickness of less than 500 nm. Further preferably, the first layer is formed to a thickness of less than 300 nm. Most preferably, the first layer is formed to a thickness of less than 200 nm.

It is preferable that during growth of a Group III-V nitride layer of the present invention, a Group III element is intermittently supplied to a growth-plane of the layer while a Group V element is supplied in a form containing radical species. The Group III element may be supplied in a form of a compound or a metal (for example, using a metal target), and a growth method is preferably pulse laser deposition (PLD).

As the form where the Group V element (nitrogen element) contains radicals, the examples include nitrogen plasma excited by a method such as UV excitation, DC excitation, ECR excitation and RF excitation, and an apparatus may be a known plasma generator used in MBE. Plasma excitation generates, as excited species, molecular radicals, atomic radicals and ions, and in the present invention, nitrogen element (excited species) supplied to a growth-plane preferably contains molecular nitrogen radicals. Atomic radicals and ions tend to cause elimination of nitrogen from the Group III-V nitride layer. Since in a nonpolar substrate, there exist a Group III element and a Group V element in the same number in a growth-plane, nitrogen elimination tends to cause practically excessiveness of Group III element in the growth-plane and to lead to generation of a droplet of a Group III element such as Ga, which would result in deterioration in crystallinity. In a conventional c-plane Group III-V nitride layer, such as in growth on a C+ plane sapphire substrate by MOCVD or growth on a C- plane ZnO substrate by PLD as in the reference experiment herein, growing is often conducted such that a growth-plane is a Ga polar face having a good surface morphology or good crystallinity of the growth layer, wherein only a Group III element such as Ga appears in the growth-plane so that nitrogen elimination from the growth-plane is substantially uninfluential. Thus, even when the excited species are atomic radicals or molecular radicals, they do not influence crystal quality very much, and according to our experiment, crystallinity was, rather, better in the case that atomic radicals are predominantly contained. In contrast, in a nonpolar plane, a thin film exhibiting excellent crystallinity was obtained using the element predominantly containing molecular radicals.

Nitrogen element (excited species) supplied to the growth-plane contains preferably 60 % or more (base on N atom) of molecular radicals, more preferably 70 % or more, particularly preferably 80 % or more, and the more the better and it is, if possible, most preferably 100 %. In Examples, it is about 90 %. This condition is effective in growth of both first and second layers.

Ion species are contained preferably in an amount of 5 % or less, more preferably 1 % or less, particularly preferably 0.1 % or less of radical species. For reducing ion species, for example, a RF plasma generator can be equipped with an ion trap. Hereinafter, a nitrogen source with a small content of ion species and predominantly containing radical species as described above is referred to as a radical source.

A content of molecular nitrogen radicals can be determined by estimating flux rates of ion species and atomic nitrogen radical, which is then subtracted from the flux of N uptaken into the crystal to obtain a difference as a rate of molecular nitrogen radicals in accordance with, for example, J. Vac. Sci. Technol., B17(4), 1999, pp.1654.

A rate of molecular nitrogen radicals varies by changing the structure and the operation conditions of the RF plasma generator. For example, it is preferable to optimally change the conditions such as a voltage for plasma generation (a low voltage is preferable), an electric power (preferably, a discharge voltage is low while a power is large), an electrode configuration, a pressure and a flow rate of a gas in the plasma generator, an electron source, the method of confining the plasma (magnetic field or the shape of a plasma cell), the type of the gas, an ion removing system and a aperture of a cell outlet (a smaller aperture is preferable).

In the above first layer growth, for the purpose of obtaining a high-quality crystal, it is also effective to increase a ratio of a Group V element to a Group III element (V/III ratio) supplied to the growth-plane. Excessive Group III in the growth-plane tends to lead to generation of a droplet of a Group III element such as Ga, resulting in deterioration in crystallinity. The layer is formed preferably in a V/III ratio of more than 1, more preferably in a V/III ratio of 2 or more, very preferably 5 or more. A V/III ratio can be determined from a ratio of the maximum growth rate, as substitute for a Group V supply amount, allowing growth keeping a stoichiometry under the same Group V supply conditions in the actual growth conditions, to a growth rate under the actual growth conditions as substitute for a Group III supply amount.

The items related to a manufacturing process described above will be detailed in the later description for a manufacturing process.

A Group III-V nitride layer of the present invention preferably has semiconductor-like electric properties. Thus, when applying this laminated structure to, for example, a light-emitting device, a part of the laminated structure can be used as a constituent element of the device structure. Generally, semiconductor-like electric conducting property means that it has an intermediate electric resistance between a metal and an insulator (as an electric conductivity, $10^3$ to $10^{-10}$ $\Omega^{-1} \cdot cm^{-1}$ at ambient temperature), which reduces as a temperature increases. This means, as well known, that the material has a band structure consisting of a conduction band zone and a valence band mutually separated by a forbidden band, and further that an element to be a dopant can be deliberately introduced to form an n-type material in which electric conduction through electrons is dominant or a p-type material in which electric conduction through holes is dominant. Thus, a Group III-V nitride layer preferably has semiconductor-like electric conducting property and it is also preferable to use a part of this layer as an element of a variety of semiconductor device structures.

Furthermore, when a band structure of a Group III-V nitride layer of the present invention is a direct transition type band structure, it can be used for a part inducing radiative recombination such as an active layer in a light-emitting device.

A Group III-V nitride layer of the present invention is formed on a substrate having a different lattice constant from the Group III-V nitride in a manufacturing process. Here, the phrase, "having a different lattice constant from a substrate" means that since a growth-plane is parallel to c-axis when a nonpolar plane is grown, a lattice constant of a hexagonal nitride layer in a c-axis direction and a lattice constant in a direction perpendicular to it (one of a-axes for m-plane and one of m-axes for a-plane) are not completely identical to a lattice constant of a substrate in a c-axis direction and a lattice constant in a direction perpendicular to it, respectively.

A substrate may be a substrate, as a principal surface, having the same hexagonal crystal plane (m-plane, a-plane and so forth) as that of a Group III-V nitride layer to be grown, or having a plane whose lattice structure is in consistent with that of the same hexagonal crystal plane (m-plane, a-plane and so forth) as that of a Group III-V nitride layer. For example, a substrate having principal surface of a plane whose lattice structure is in consistent with that of m-plane {1-100} plane in a hexagonal crystal may be a substrate having a cubic system crystal structure. Generally, it is preferable to use a substrate having a crystal structure belonging to hexagonal crystal in which a nominal plane orientation of a principal surface is identical to that of a Group III-V nitride layer to be grown. By using a substrate having an identical plane orientation, when a nitride layer is grown on the substrate, crystal information of the substrate is transferred and thus a nitride layer having a desired nonpolar plane as a growth-plane can be easily formed.

Herein, the term "a nominal plane orientation of a principal surface" means that a principal surface of the substrate is allowed to be deviated from perfect perpendicularity to a crystal orientation. Generally, an axis perpendicular to a principal surface may be deviated within a range of 15°, preferably 5° from the crystal orientation. In, for example, GaN, sapphire or ZnO having a hexagonal crystal structure, a plane perpendicular to {0001} is a plane in which anions and cations of its constituent elements exist in the same number, so that it is a nonpolar plane which does not exhibit polarity.

Specific examples of a substrate include, but not limited to, single crystal substrates such as sapphire, Si, spinel (MgAl$_2$O$_4$), NdGaO$_3$, ZnO, MgO, SiO$_2$, GaAs, GaP, InP, ZnSe, ZnTe and CdTe. In particular, preferred is a substrate containing zinc and oxygen as constituent elements, particularly preferably a ZnO substrate. ZnO has a crystal structure belonging to hexagonal crystal, where a lattice mismatch with GaN is as small as 0.4 % in c-axis and 1.9 % in a-axis, and thus it is suitable for growth of a GaN-containing hexagonal system nitride layer.

A substrate surface is particularly preferably flat. Generally, a surface roughness Ra is preferably 3 nm or less, more preferably 2 nm or less, further preferably 1.7 nm or less. A Ra denotes an arithmetic average roughness, which is an average of an absolute value of a deviation from an arithmetic average value. A method for obtaining a flat substrate surface depends on a substrate material and a plane orientation, and it is, therefore, preferable to employ a method suitable for each case to satisfy the above condition for a surface roughness. Generally, it is preferable to first conduct mechanical polishing for adequate planarization.

For a m-plane ZnO substrate, it is preferable to use a substrate further annealed at 800 °C or higher. As described in Examples, an appropriately polished substrate can be annealed to provide such a flat substrate that an atomic layer step can be observed.

For an a-plane ZnO substrate, in order to obtain a flat surface roughness as described above, it is instead important that the annealing at a high temperature is not conduct. Annealing at a high temperature causes a stripe texture in a surface, leading to deterioration in surface flatness. Using such an a-plane ZnO substrate, a Group III-V nitride layer exhibiting good crystallinity was not obtained as described in Examples. When applying an approach commonly used for c-plane growing in the prior art as it is, a Group III-V nitride layer exhibiting good crystallinity cannot be obtained.

Generally, in a nonpolar plane ZnO except m-plane, annealing is not conducted or conducted without losing the above flatness. Annealing can be conducted as necessary because it can recover surface scratching damages and the like. Annealing, if adopted, is conducted generally at 700 °C or higher, preferably at 800 °C or higher. When the above condition for surface roughness is met, annealing does not have to be conducted. For a-plane, it is preferably annealed at a temperature of less than 1150 °C or not annealed. Annealing is, if annealed, conducted more preferably at a temperature of less than 1100 °C, particularly preferably at a temperature of 950 °C or lower. For another polar plane (except m-plane and a-plane), annealing is also conducted at a temperature of less than 1150 °C. Likewise, for m-plane, when the condition for surface roughness described above is met, annealing may not be conducted or may be conducted at a temperature of less than 800 °C (generally at 700 °C or higher), but as described above, it is preferable to conduct annealing.

The present invention does not use a substrate containing Li as a principal constituent element or a substrate containing C as a principal constituent element. Li diffuses very extensively in a nitride semiconductor and significantly affects its electric properties, making it difficult to control semiconductor conductivity. When a substrate contains Li, Li can easily diffuse into a nitride layer formed on the substrate. A substrate such as LiAlO$_2$ containing Li as a principal constituent element is, therefore, not used in the present invention. Even when a substrate material does not contain Li as a principal constituent element, it is preferable that a content of Li as a dopant is small, preferably 10$^{21}$ (cm$^{-3}$) or less. In terms of C, when it enters a Group III-V semiconductor layer, it may become amphoteric impurities, adversely affecting conductivity control of the layer. Generally, a layer containing C in a high concentration may deteriorate reliability of a light-emitting device and therefore, it is not desirable to use SiC as a substrate for growth for manufacturing an actual light-emitting device.

A Group III-V nitride layer of the present invention as described above can be used in various applications. The Group III-V nitride layer of the present invention may be in the form of a substrate provided for forming a device structure on it, in the form of a part of a device where a device structure is formed on the layer, in the form of a part of a device where at least a part of a device structure is formed on a part of the layer, or in any other form. A substrate such as ZnO used in growth of a Group III-V nitride layer may remain as it is or may be removed in an appropriate step. In other words, a final or intermediate product having a Group III-V nitride layer of the present invention may or may not have a substrate used for the growth.

Next, a laminate structure of the present invention has, on a Group III-V nitride layer, other layer(s) (i.e. additional layer(s)) which is different from the former. The other layer(s) may be of any type; its material may include an insulating material, a semiconductor part or a metal part. It may be formed by a well-known film deposition method including hydride vapor deposition (HVPE); CVD processes such as organic metal vapor deposition (MOCVD), plasma chemical vapor deposition (CVD) and thermal CVD; molecular beam epitaxy (MBE); sputtering and evaporation; and PLD. A structure formed may be a single-layer or multilayer structure, and in addition it may be a device structure such as a so-called electron device or light-emitting device.

However, for achieving full function of a high quality Group III-V nitride layer of the present invention, the layer directly laminated thereon is preferably such a layer that high quality is attained by using the layer of the present invention as a base layer. In particular, it is preferable that at least a part of a layer directly contacting the layer of the the present invention is a lattice matching layer. For example, preferred is a Group III-V nitride layer formed with a different composition or by a different growth process. The deposition process is preferably selected from VPE, CVD, MBE, sputtering, evaporation and any combination of two or more of these.

A Group III-V nitride layer of the present invention and the other layer(s) laminated on it have different film properties when being formed by different processes, even when their principal composition or desired composition is identical. In other words, they can be generally distinguished as two different layers because the amount of a contained dopant is different between these two layers or an interface may be observed from a dopant profile of the interface between these two layers. For example, in a preferred embodiment of the present invention, an inventive Group III-V nitride layer is grown by PLD while the other layer(s) is deposited by, for example, common MOVPE. In GaN layer deposition as an example, since MOVPE generally uses $NH_3$ and an organic metal such as TMG (trimethylgallium Ga $(CH_3)_3$) as starting materials and hydrogen or nitrogen gas as a carrier gas, its impurities tends to inevitably contain hydrogen and carbon and generally contain oxygen. In contrast, in the case of growth by PLD, nitrogen radicals can be generated using nitrogen gas as a nitrogen source and a metal such as Ga can be used as a starting material, which reduces hydrogen or carbon in principle, and the impurities contained are in a different level from that in a film formed by MOVPE. Therefore, a Group III-V nitride layer of the present invention and "the other layer(s)" can be generally distinguished.

Manufacturing process

There will be described a process for manufacturing a Group III-V nitride layer of the present invention.

A manufacturing process of the present invention is a process for growing a Group III-V nitride layer belonging to hexagonal crystal on a substrate having a different lattice constant, with the proviso that a substrate containing Li as a principal constituent element is excluded,
the process comprising the growing steps of:

(a) providing a substrate having, as a principal surface, a hexagonal nonpolar plane or a plane having a lattice structure identical to that of the hexagonal nonpolar plane,
(b) growing the Group III-V nitride layer on the principal surface of the substrate at least in two steps, comprising
(b-1) a first sub-growing step of growing a first layer on the principal surface of the substrate at a growth temperature of lower than 500 °C while maintaining a single crystal structure on the growth-plane, and
(b-2) a second sub-growing step of growing a second layer on the first layer at a growth temperature of 400 °C or higher and higher than the growth temperature in the first sub-growing step.

Here, a nonpolar plane is, as defined above, a plane whose orientation is satisfying the condition of 1 = 0 when a plane orientation is expressed as {ijkl} (except {0000}). Examples of typical planes include m-plane{1-100}plane, a-plane{11-20}plane, {12-30}plane and {13-40}plane, preferably m-plane and a-plane, particularly preferably m-plane.

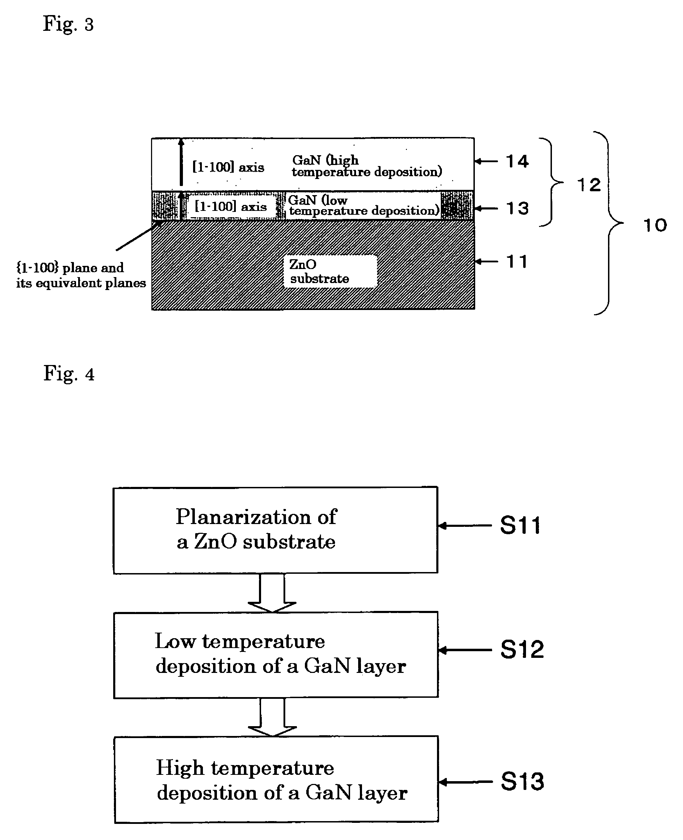

FIGs. 3 and 4 show an example where a m-plane ZnO substrate is used as a substrate and a GaN layer is formed as a Group III-V nitride layer. While a substrate which can be used is as described above, it is preferable to provide a substrate adequately planarized as a substrate or to planarize a substrate as a part of a manufacturing process. As a result, it is enough if ZnO substrate with a surface roughness Ra of 3 nm or less, preferably 2 nm or less, further preferably 1.7 nm or less is provided. A process for providing a substrate will be separately described for a m-plane ZnO substrate and a nonpolar plane ZnO substrate other than m-plane.

Preparation of a m-plane ZnO substrate

In an embodiment using a m-plane ZnO substrate, it is preferable to conduct annealing at a high temperature of 800 °C or higher as a substrate planarization step (S11) as shown in the flow chart of FIG. 4. The temperature is generally 1600 °C or less. Specifically, a ZnO substrate 11 having mechanically polished {1-100}plane as a principal surface is heated surrounded by a ZnO sintered body as a box in a high temperature oven controlled at a temperature of 800 °C or higher. Here, it is enough that the ZnO substrate 11 is surrounded by the ZnO sintered block, and it is not essential that the ZnO substrate 11 is completely enclosed in the surrounding sintered block. Alternatively, for example, a crucible made of a ZnO sintered material may be prepared and the ZnO substrate 11 may be placed within it. Surrounding of ZnO is for preventing Zn with a relatively higher vapor pressure from escaping, so that instead of a ZnO sintered block, a Zn-containing material may be used in such surrounding. Examples of a Zn-containing material may include ZnO single crystal and a Zn plate.

By heating the ZnO substrate 11 on the basis of the above condition, a ZnO substrate 11 which is flat in such an atomic layer level that an atomic step is formed can be applied as a substrate for crystal growth and thus an excellent GaN thin film can be formed on it.

Preparation of a nonpolar plane ZnO substrate other than m-plane

For a nonpolar plane ZnO substrate other than m-plane (for example, a-plane), a ZnO substrate is provided, whose surface roughness Ra is 3 nm or less, preferably 2 nm or less, further preferably 1.7 nm or less. The ZnO substrate surface is, first, mechanically polished (including chemical mechanical polishing), in which it is preferable to adequately planarize it to a level that the surface roughness is within the above range. If adequately planarized, the substrate does not have to be annealed. However, it may be annealed for improving flatness and/or reducing fine scratches, and generally it may be preferable to anneal the substrate within a range where the above flatness can be obtained.

The annealing is conducted at a temperature of preferably less than 1150 °C, more preferably less than 1100 °C, particularly preferably 950 °C or lower. Furthermore, the annealing is conducted generally at a temperature of 700 °C or higher, preferably 800 °C or higher. An annealing process is same as described for the above m-plane ZnO substrate.

After preparing a substrate having a predetermined plane orientation as described above, a first layer of a Group III-V nitride layer is formed over a substrate. In (b-1) the first sub-growing step for forming the first layer, the growth is conducted at a growth temperature of less than 500 °C, preferably while maintaining a single crystal structure on a growth-plane (corresponding to S12 in FIG. 4).

By growing the layer on a substrate at a temperature of less than 500 °C, an interface reaction with the substrate and a Group III-V nitride layer such as $In_xAl_yGa_{(1-x-y)}N$ does not occur and thus an interface reaction layer is not formed, even when the substrate is ZnO. At a growth temperature of 500 °C or higher, a crystal with insufficient quality is often obtained.

In the first sub-growing step (the low-temperature growth step S12) of the present invention, it is preferable that the first layer is grown while maintaining a single crystal structure on a growth-plane. This can be monitored by observing a RHEED image of the growth-plane as described in Examples.

A growth temperature is further preferably a temperature of 450 °C or lower. A growth temperature of the first layer may be less than 0 °C such as 77 K in principle, but it is generally 0 °C or higher, for example 10 °C or higher, practically preferably room temperature (20 to 30 °C) or higher. In one embodiment of the present invention, it is selected from a range of room temperature to 450 °C, and in another aspect, may be selected from a range of 100 °C to 450 °C. Alternatively, it may be selected from a range of 250 °C to 400 °C.

There are no particular restrictions to the growing method of the first layer in the first sub-growing step as long as the growing can be conducted at a temperature of less than 500 °C while maintaining a single crystal structure in the growth-plane. In one embodiment of the present invention, a Group III element is intermittently supplied to the growth-plane and a Group V element (N) is supplied in the form containing radicals, presumably by which the growth while maintaining a single crystal structure is attained. Intermittent supplying of the starting materials to the substrate is considered to enhance migration of atoms which have arrived at the growth surface to grow a high quality crystal. For the Group V element, excited species which can be involved in the growth include ions and radicals, but it is preferable to supply the element such that a concentration of radicals in the excited species is high. We suppose that radicals as the excited species is effective for growing a high-quality crystal.

It is preferable to select the conditions such that nitrogen element (excited species) supplied to a growth-plane contains molecular nitrogen radicals in a large amount. Nitrogen element supplied to the growth-plane contains preferably 60 % or more (based on N atoms) of molecular radicals, more preferably 70 % or more, particularly preferably 80 % or more, and the more the better. If possible, it is most preferably 100 %. In Examples, it is about 90 %.

Among the nitrogen element (excited species) supplied, ion species are contained preferably in an amount of 5 % or less, more preferably 1 % or less, particularly preferably 0.1 % or less of radical species.

A percentage of molecular nitrogen radicals varies by changing the structure and the operation conditions of the RF plasma generator; for example, it is preferable to optimally change the conditions such as a voltage allowing for plasma generation (a low voltage is preferable), an electric power (preferably, a discharge voltage is low while a power is large), an electrode configuration, a pressure and a flow rate of a gas in the plasma generator, an electron source, the method of confining the plasma (magnetic field and the shape of a plasma cell), the type of the gas, an ion removing system and a aperture of a cell outlet (a smaller aperture is preferable).

The layer is formed under the condition such that a ratio of a Group V element to a Group III element supplied to the growth-plane (V/III ratio) is preferably more than 1, more preferably 2 or more, very preferably 5 or more.

When a growth rate of the first layer is too large, atoms which have arrived at the substrate surface cannot adequately migrate. In particular, in growth at a low temperature, crystal quality is deteriorated because kinetic energy for migration cannot be supplied by thermal energy from a substrate temperature. Therefore, a growth rate of the first layer is, for example, preferably less than 300 nm/hr. It is further preferably 200 nm/hr or less, most preferably 160 nm/hr or less. When the growth rate is too small, impurity incorporation is increased, and in particular, in growth at a low temperature, impurities in a growth chamber tend to be adsorbed in comparison with growth at a high temperature, leading to deterioration in a crystal quality. Therefore, a growth rate of the first layer is, for example, preferably more than 10 nm/hr, further preferably 30 nm/hr or more.

In terms of the conditions for a cycle of intermittent supply of a Group III element, when a stop period between supply periods is too short, atoms which have arrived at the substrate surface cannot adequately migrate, leading to deterioration in crystal quality. When a stop period is too long, a growth rate is reduced; and due to long discontinuation of growth, impurity incorporation into a growth film increases, leading to deterioration in crystal quality. Therefore, a supply stop period is preferably within a range of 0.001 sec to 10 sec, more preferably 0.005 sec to 1 sec, particularly preferably 0.01 sec to 0.5 sec, most preferably 0.02 sec to 0.1 sec. A supply period may be appropriately selected within the above range for a growth rate, for example, $1 \times 10^{-13}$ sec to 10 sec.

A typical growth method in which starting materials are intermittently supplied is PLD. In PLD, material atoms are excited as plasma by intermittent pulse laser irradiation, which is supplied to a substrate, so that even when the substrate is at a low temperature, atoms have kinetic energy required for migration on the substrate surface and thus the method is suitable for growth at a low temperature.

Any intermittent irradiation source may be used in place of laser as long as it gives a pulse particle flux allowing for excitation of source material atoms, including electrons, cluster ions, protons and neutrons.

An alternative growth method where starting materials are intermittently supplied may be migration enhanced epitaxy (MEE) or a flow-rate modulation method, in which a Group III material and a Group V material are alternately and in each case intermittently supplied.

In PLD growth, a Group III element may be supplied either as a compound or as a metal(for example, using a metal target).

In growth at a low temperature, particles which have arrived at a substrate inadequately migrate. As a film thickness increases, crystallinity tends to be deteriorated. Therefore, for a favorable crystal structure, a thickness of the first layer is particularly preferably less than 500 nm (preferably less than 300 nm, particularly preferably less than 200 nm).

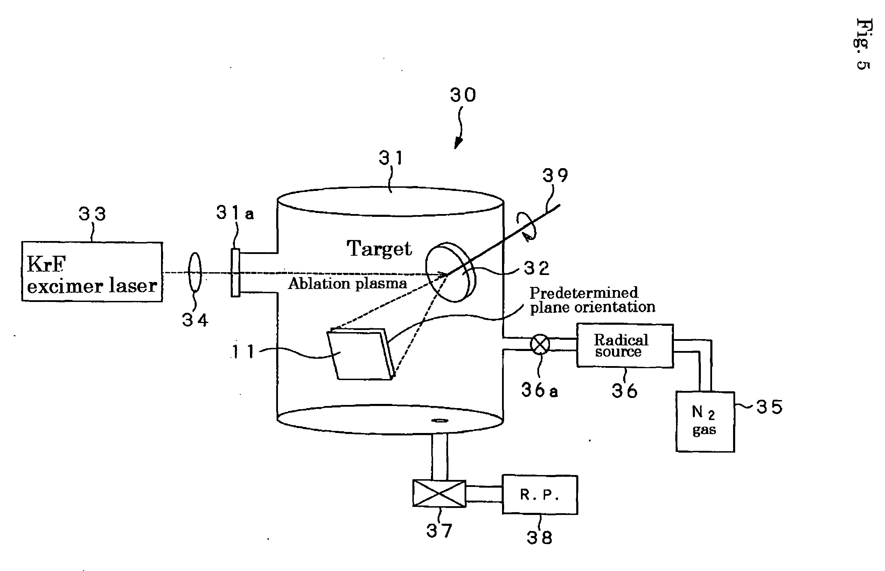

There will be detailed a PLD process. Here, for example, there will be described an example where using a PLD apparatus 30 as shown in FIG. 5, an $In_xAl_yGa_{(1-x-y)}N$ layer is formed on a ZnO substrate 11 as a substrate.

The PLD apparatus 30 has a chamber 31 forming an enclosed space for keeping a pressure and a temperature of a gas filled in the inside constant. Within the chamber 31, a ZnO substrate 11 and a target 32 are placed, facing each other. Here, the target 32 may be selected from gallium metal, indium metal, aluminum metal, AlGa alloy, InGa alloy, AlInGa alloy, GaN single crystal, InN single crystal, AlN single crystal, GaInN single crystal, AlGaN single crystal, AlInGaN single crystal, sintered GaN, sintered InN, sintered InGaN, sintered AlGaN and sintered AlInGaN. Depending on the growth conditions, selection of target species and selection either single- or multi-target deposition can be appropriately determined.

Furthermore, PLD apparatus 30 has a KrF excimer laser 33 emitting a high output pulse laser with a wavelength of 248 nm. A pulse laser beam emitted from the KrF excimer laser 33 is adjusted by a lens 34 such that its focus position is near target 32, and is directed to the surface of the target 32 at an angle of about 30 ° placed in the chamber 31 through a window 31a.

The PLD apparatus 30 further has a gas supply unit 35 for introducing nitrogen gas into the chamber 31 and a radical source 36 for exciting the nitrogen gas into radicals. The nitrogen radical source 36 first excites, using a high frequency, the nitrogen gas discharged from the gas supply unit 35 into nitrogen radicals, which are then supplied into the chamber 31. Between the chamber 31 and the gas supply unit 35, there is provided an adjusting valve 36a for controlling a gas concentration for controlling an adsorption state to the ZnO substrate 11 in concerned with a relationship between nitrogen radical gas and a wavelength of the pulse laser beam.

The PLD apparatus 30 further has a pressure valve 37 and a rotary pump 38 for controlling a pressure in the chamber 31. A pressure in the chamber 31 is controlled by the rotary pump 38, taking the PLD process including deposition under reduced pressure into account, for example, such that a predetermined pressure is obtained in a nitrogen atmosphere.

The PLD apparatus 30 further has a rotation axis 39 for rotating the target 32 in order to move a point of pulse laser beam irradiation.

In the above PLD apparatus 30, while the chamber 31 is filled with nitrogen gas and the target 32 is rotation-driven through a rotation axis 30, a pulse laser beam is intermittently irradiated. Thus, a surface temperature of the target 32 can be steeply increased to generate ablation plasma containing Ga, In and Al atoms (when all of these atoms are contained in the target). Ga, In and Al atoms contained in the ablation plasma move to the ZnO substrate 11 while gradually changing their states, for example, by repeating a collision reaction with nitrogen gas. Then, the particles containing Ga, In and Al atoms arriving at the ZnO substrate 11 diffuse on a nonpolar plane on the ZnO substrate 11 as they are, to form a thin film with the most stable state for lattice matching.

Although this first layer appears to be similar to a low temperature buffer layer formed by a conventional MOVPE process, its layer structure is considerably different from the latter. Generally, when a Group III-V nitride layer is grown on a substrate such as sapphire by MOVPE, a substrate temperature for epitaxial growth of GaN in MOVPE is about 900 to 1100 °C, while a low temperature buffer layer is formed at about 500 to 600 °C. The GaN or AlN buffer layer deposited at a substrate temperature of about 500 to 600 °C to about 20 to 100 nm thickness consists of fine polycrystal structures. When a substrate temperature is increased to about 1000 °C for growing, for example, GaN on this layer, some of the polycrystal structures are converted into a single crystal by solid-phase growth, which advances the orientation of the crystal. Thus, on a buffer layer whose structure has been changed, is epitaxially grown a single crystal nitride layer at a high temperature of about 900 to 1100 °C.

In contrast, a first layer grown in the first sub-growing step according to the present invention is totally different from the above-mentioned buffer layer in that it has not a multicrystal structure, but a single crystal structure whose crystal orientation is aligned from the initial growth stage. In the first sub-growing step of the present invention, a single crystal is grown from the initial growth stage while preventing an interface reaction between the substrate and the growth layer.

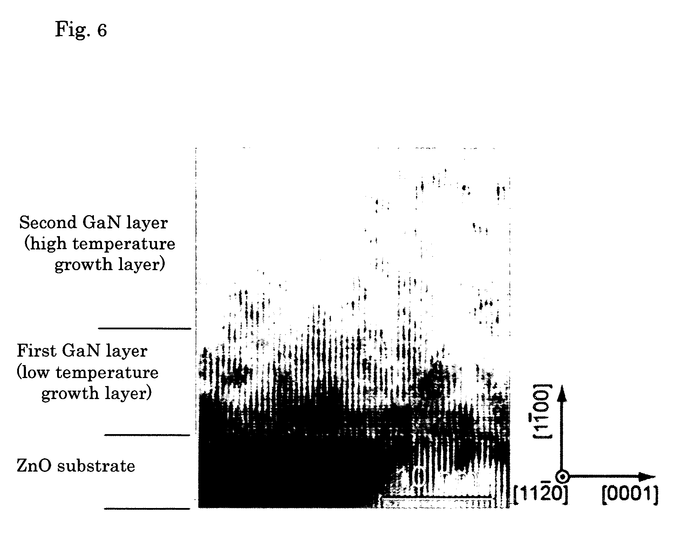

FIG. 6 shows a cross-sectional TEM image of a GaN layer grown under the growth conditions as described in Example 6 later, from [11-20] direction. The figure shows that a high-quality GaN single crystal layer is grown from a ZnO substrate interface without formation of an interface reaction layer between the ZnO substrate and the GaN growth layer.

Furthermore, cross-sectional TEM observation of the same sample as the above GaN layer from [0001] direction indicates that although a lattice mismatch rate in a-axial direction is as high as 1.9 % in a GaN crystal and a ZnO crystal, there is grown a high-quality GaN single crystal layer having a lattice image continuous from a lattice image of the ZnO substrate interface. This TEM image was analyzed in detail and each lattice distance in a-axial direction of following were compared, (A) a GaN crystal at the point 18 nm from the ZnO substrate interface in the GaN layer, (B) a GaN crystal near the ZnO substrate interface, (C) a ZnO crystal near the ZnO substrate interface, (D) a ZnO crystal at the point about 50 nm from the ZnO substrate interface in the ZnO substrate, and it provided the relationship of (lattice spacing at point B) < (lattice spacing at point C) < (lattice spacing at point A) < (lattice spacing at point D). Generally, in crystal growth on a substrate having a different lattice constant, a growth layer crystal grown on the substrate is strained for lattice constant matching with the substrate, but the above relationship indicates that the ZnO crystal as a substrate is contracted near its growth interface to conform with a lattice constant of the grown GaN crystal. Furthermore, it is observed that the GaN crystal and the ZnO crystal near the ZnO substrate interface have a further smaller lattice constant than that of the GaN crystal, indicating a very unusual interface crystal structure. As a well-known mechanism of epitaxial growth on a substrate having a different lattice constant, there are three growth modes, that is, a FM mode (Frank-Van der Merwe mode: a mechanism where a crystal grown on a substrate extends by one-atom layers for increasing its thickness. This is a mechanism expected in the case where a lattice constant of the crystal grown on the substrate is close to a lattice constant of a substrate crystal), a VW mode (Volmer-Weber mode: a mechanism where a crystal grown on a substrate forms a three-dimensional nucleus and is three-dimensionally grown as it is. This is a mechanism expected in the case where a lattice constant of the crystal grown on the substrate is significantly different from a lattice constant of a substrate crystal or a binding strength between these crystal at the interface is weak), and a SK mode (Stransky-Krastanov mode: an intermediate mechanism between the FM and the VM modes where growing of a crystal grown on a substrate is initiated in the FM mode and, once a given critical film thickness defined by a strain accumulation in the growth layer is exceeded, a three-dimensional nucleus is formed and then three-dimensional growth is initiated). In all of these, it has been believed that lattice mismatch with a substrate is adjusted by inherent strain in the crystal layer grown on the substrate. It is unknown that a lattice constant in the substrate varies.

In contrast, in the phenomenon of the present case, the lattice mismatch between the substrate and the growth layer is adjusted by variation of a lattice constant of the substrate which is a base of a grown crystal layer. And this can be understood to be a physical phenomenon completely different from an epitaxial growth mechanism known in the prior art.

Although the reason why such a single crystal growth mechanism occurs is not clear, it is suspected that it would be caused by an adequately "soft" elastic property of the substrate as a base in comparison with a crystal layer grown on the substrate. Furthermore, it would be partly caused by the fact that a difference in a lattice constant is not so large but relatively small.

Meanwhile, the cross-sectional TEM image in FIG. 6 shows that a lattice constant in a c-axis direction in the side of a GaN crystal grown on the substrate is fixed to conform with a lattice constant of the ZnO crystal as a substrate. Therefore, depending on a crystal axial direction, the layer that varies lattice constant to satisfy lattice match is different, which is a feature different from those in a growth mechanism known in the prior art. These analysis results can be considered an important factor in growing a growth layer having excellent crystallinity even on a substrate having a different lattice constant according to the aspects of the present invention. This indicates the significant advantageous effectiveness of the present invention.

Next, the second sub-growing step is (b-2) a step where a second layer is grown on the first layer at a growth temperature of 400 °C or higher and higher than the growth temperature in the first sub-growing step. In the example shown in FIGs. 3 and 4, on the first layer (the GaN low temperature growth film 13 in FIG. 3) grown in the first sub-growing step (the low temperature deposition step S12), the second layer is grown (the GaN high temperature growth film 14 in FIG. 3) in the second sub-growing step (the high temperature growth step S13).

The second sub-growing step requires a temperature that excited species or particles adequately migrate on the growth-plane during growth of the Group III-V nitride to prevent defects from generating in the course of epitaxial growth.

A growth temperature in the second sub-growing step is preferably 400 to 1300 °C, more preferably 550 to 1200 °C, particularly preferably 600 to 850 °C. The range of 400 °C or higher and less than 500 °C is allowed when it is higher than the temperature in the first sub-growing step.

A growth rate of the second layer is for example 30 to 5000 nm/hr, preferably 50 to 3000 nm/hr, further preferably 70 to 1000 nm/hr. Generally, it is preferably larger than the growth rate of the first layer. For significantly reducing twist (s) (b1 to b4) which is more influential on device performance among the mosaic structures of a crystal, a growth rate of the second layer is preferably 120 to 5000 nm/hr, more preferably 150 to 3000 nm/hr, particularly preferably 200 to 1000 nm/hr. It is quite noteworthy that a twist component in crystallinity fluctuation can be reduced by adjusting a growth rate of the second layer.

There are no particular restrictions to a growth method of the second sub-growing step as long as such growth can proceed to provide a favorable crystal structure, but as described for the first sub-growing step, preferred is a process where a Group III element is intermittently supplied to a growth-plane while a Group V element is supplied in a form containing radical species. In particular, it is especially preferable to supply a Group V element such that a concentration of radicals as the excited species is high. In the second sub-growing step, the radicals of the Group V element as the excited species are again considered effective for growing a high-quality crystal. In particular, it is preferable to select the conditions such that percentage of the molecular nitrogen radical species is increased. Nitrogen element supplied to the growth-plane contains molecular radicals preferably in an amount of 60 % or more (based on N atoms), more preferably 70 % or more, particularly preferably 80 % or more, and the more the better. If possible, it is most preferably 100 %. In Examples, it is about 90 %. Nitrogen element supplied (excited species) contains ion species preferably in an amount of 5 % or less, more preferably 1 % or less, particularly preferably 0.1 % or less of radical species.

The second sub-growing step may be grown by, for example, MBE or MOVPE, but preferably by PLD which is a typical growing method employing intermittent supply of starting materials. In a preferable embodiment of the present invention, the first layer is grown by PLD, and it is, therefore, preferable to grow the second layer also by PLD because it can provide good layer continuity, can form the layers in the same chamber, avoiding causes of contamination and is advantageous in the light of convenience in production. The details of PLD are as described for the first sub-growing step.

In the example in FIG. 3, on the ZnO substrate 11 is thus formed a laminated structure 10 having the Group III-V nitride layer 12 containing the GaN low-temperature deposition layer 13 and the GaN high-temperature deposition layer 14.

The second to the fourth aspects of the present invention are as follows. Although in the above aspect (the first aspect of the manufacturing process of the present invention), growing is conducted while maintaining a single crystal structure on the growth-plane in the first sub-growing step, these second to fourth aspects are defined only by the following items. However, the individual conditions are substantially as described for the first aspect of the present invention, and the details of, for example, the individual materials, the steps and the conditions in the second to the fourth aspects of the manufacturing process may be as described above unless there is any discrepancy. Furthermore, preferable forms and conditions are also as described above unless there is any discrepancy.

Specifically, the second aspect of the present invention is a process for growing a Group III-V nitride layer belonging to hexagonal crystal on a substrate having a different lattice constant, with the proviso that a substrate containing Li as a principal constituent element is excluded,
the process comprising the growing steps of:

(a) providing a substrate having a hexagonal system nonpolar plane or a plane having a lattice structure identical to that of the hexagonal nonpolar plane,
(b) growing the Group III-V nitride layer on the principal surface of the substrate at least in two steps, comprising
(b-1) a first sub-growing step of growing a first layer on the principal surface of the substrate at a growth temperature of lower than 500 °C and a growth rate of more than 10 nm/hr and less than 300 nm/hr, and
(b-2) a second sub-growing step of growing a second layer on the first layer at a growth temperature of 400 °C or higher and higher than the growth temperature in the first sub-growing step.

The third aspect of the present invention is a process for growing a Group III-V nitride layer belonging to hexagonal crystal on a substrate having a different lattice constant, with the proviso that a substrate containing Li as a principal constituent element is excluded,
the process comprising the growing steps of:

(a) providing a substrate having a hexagonal nonpolar plane or a plane having a lattice structure identical to that of the hexagonal nonpolar plane,

(b) growing the Group III-V nitride layer on the principal surface of the substrate at least in two steps, comprising (b-1) a first sub-growing step of growing a first layer on the principal surface of the substrate at a growth temperature of lower than 500 °C while intermittently supplying a Group III element with a supply stop period in the range of 0.001 sec to 10 sec, and

(b-2) a second sub-growing step of growing a second layer on the first layer at a growth temperature of 400 °C or higher and higher than the growth temperature in the first sub-growing step.

The fourth aspect of the present invention is a process for growing a Group III-V nitride layer belonging to hexagonal crystal on a substrate having a different lattice constant, with the proviso that a substrate containing Li as a principal constituent element is excluded,

the process comprising the growing steps of:

(a) providing a substrate having a hexagonal nonpolar plane or a plane having a lattice structure identical to that of the hexagonal system nonpolar plane,

(b) growing the Group III-V nitride layer on the principal surface of the substrate at least in two steps, comprising (b-1) a first sub-growing step of growing a first layer on the principal surface of the substrate at a growth temperature of lower than 500 °C and a growth rate of more than 10 nm/hr and less than 300 nm/hr while intermittently supplying a Group III element with a supply stop period in the range of 0.001 sec to 10 sec, and

(b-2) a second sub-growing step of growing a second layer on the first layer at a growth temperature of 400 °C or higher and higher than the growth temperature in the first sub-growing step.

Then, for preparing a laminated structure of the present invention, that is, a laminated structure of Group III-V nitride layers and "the other layer(s)" (i.e. additional layer(s)) on the layer, "the other layer(s)" is appropriately formed on the Group III-V nitride layer, depending on their materials by a known method. In the case where a Group III-V nitride layer of the present invention is formed by PLD, "the other layer(s)" does not necessarily have to be formed by PLD, and may be formed, using a well-known deposition process such as hydride VPE, MOVPE, plasma CVD, thermal CVD, MBE, sputtering and evaporation, depending on, for example, the layer materials such as an insulator, a semiconductor and a metal. In one embodiment of the present invention, a deposition method is selected from the group consisting of VPE, CVD, MBE, sputtering, evaporation and a combination of two or more of these. A formed structure may be a single-layer or multilayer structure, or alternatively, a device structure such as a so-called electron device or light-emitting device. When "the other layer(s)" constitutes a device structure or a part of a device structure, the device structure can be again formed by a known process.

EXAMPLES

There will be further detailed the present invention with reference to Examples. In the following description, the flow chart in FIG. 4 is referred as appropriate. First, an example of m-plane growth will be described.

Example A-1

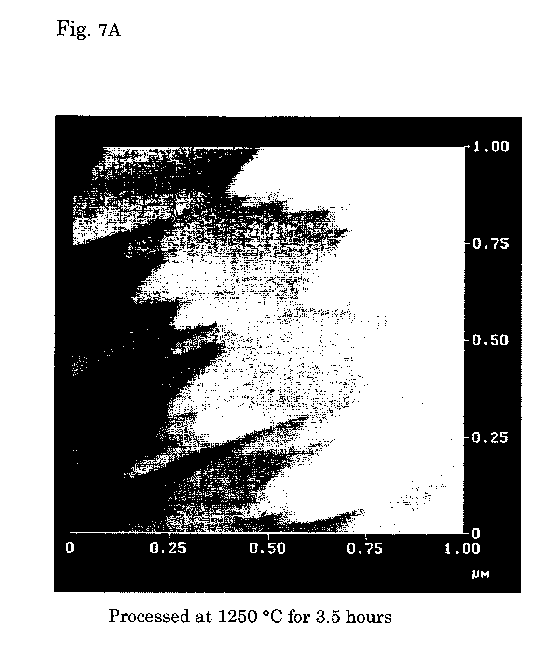

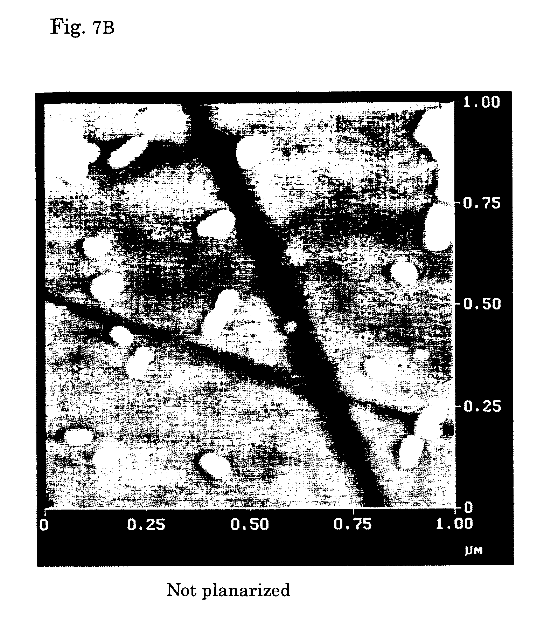

A ZnO substrate 11 having (1-100) plane as a principal surface was annealed at 1250 °C for 3.5 hrs in the planarization step S11. FIG. 7A shows an atomic force microscopy image after the planarization and, for comparison, FIG. 7B shows an atomic force microscopy image before the planarization. After the planarization, an atomic layer step was observed.

Then, the above planarized ZnO substrate was introduced into a PLD apparatus, and a GaN layer 13 as a first layer was then deposited in the low temperature deposition step S12 (the first sub-growing step). In the low temperature deposition step S12, the target 32 was made of Ga metal (purity: 99.99 %). The target 32 was placed in parallel with (1-100) plane of the ZnO substrate 11. A RF radical source was used as a nitrogen source at 300 W, and a growth pressure was $3 \times 10^{-6}$ Torr.

A pulse frequency of a pulse laser beam outgoing from a KrF excimer laser 33 was 30 Hz, an irradiation time per 1 pulse was 20 ns, and a laser power at the point of target irradiation was 0.36 W. A substrate temperature of the ZnO substrate 11 was 300 °C and the layer was grown to a thickness of 12 nm. A growth rate was 47 nm/hr.

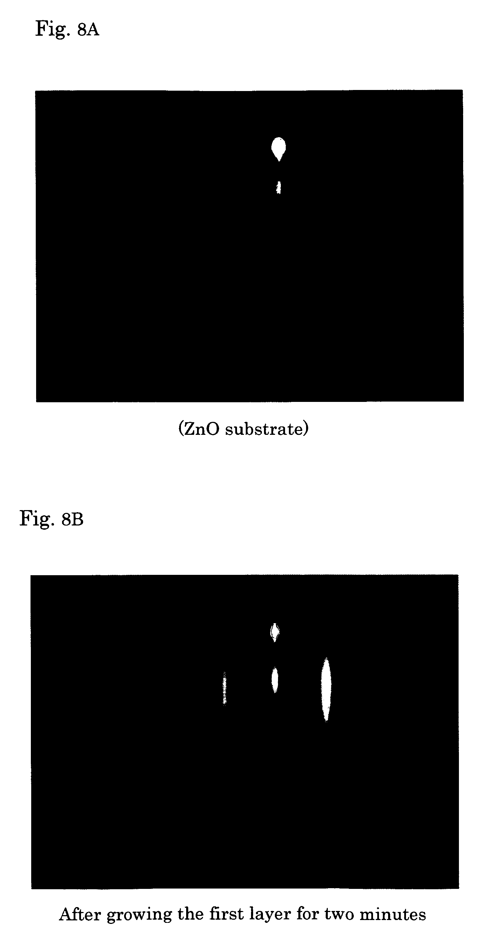

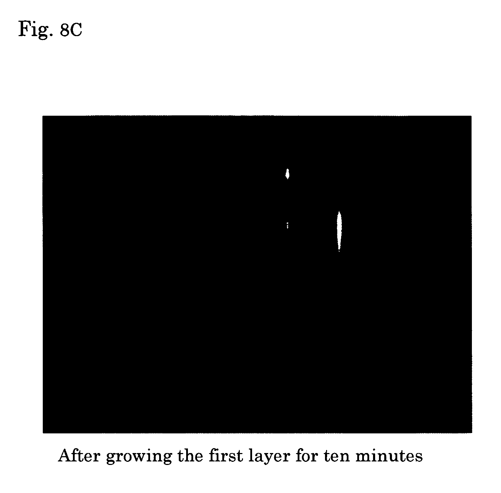

FIGs. 8A, 8B and 8C show RHEED images of ZnO substrate, after two-minute growth (1.6 nm), and after ten-minute growth (8 nm) in this growth process, respectively. Since RHEED images in FIGs. 8B and 8C show a distinct two-dimensional diffraction streak pattern, it is indicated that the GaN layer was grown while maintaining single crystal having a very flat growth-plane from the initial growth stage.

Subsequently, in the high temperature deposition step S13 (the second sub-growing step), a GaN layer 14 as a second layer was deposited. In the high temperature growth step S 13, the target 32 was made of Ga metal (purity:

99.99 %). The target 32 was placed in parallel with (1-100) plane of the ZnO substrate 11. A RF radical source was used as a nitrogen source at 400 W, and a growth pressure was $4.5 \times 10^{-6}$ Torr. A pulse frequency of a pulse laser beam outgoing from the KrF excimer laser 33 was 50 Hz and a laser power at the point of target irradiation was 0.86 W. In the high temperature deposition step S13, a substrate temperature of the ZnO substrate 11 was 700 °C. The layer was grown to a film thickness of about 300 nm. A growth rate was about 300 nm/hr.

The GaN layer thus obtained was evaluated for its crystal mosaic structure by X-ray rocking curve measurement. Table 1 shows the growth conditions and Table 2 shows the evaluation results for the film obtained. A V/III ratio estimated in the low temperature deposition step S12 is also indicated in the right column in Table 2.

Example A-2

Deposition was conducted as described in Example A-1, except that in the low temperature deposition step S 12, a RF radical source as a nitrogen source was used at 400 W, a substrate temperature was 320 °C, a growth rate was 53 nm/hr, a growth film thickness was 13 nm; and in the high temperature growth step S13, a laser power at the point of target irradiation was 0.93 W and a substrate temperature was 690 °C. The layer was grown to a thickness of about 300 nm. A growth rate was about 300 nm/hr. The resulting layer was evaluated as described in Example A-1. Table 1 shows the growth conditions and Table 2 shows the evaluation results for the film obtained.

Example A-3

Deposition was conducted as described in Example A-1, except that in the low temperature deposition step S12, a RF radical source as a nitrogen source was used at 400 W, a substrate temperature was room temperature, a laser power at the point of target irradiation was 0.42 W, a growth rate was 107 nm/hr, a growth film thickness was 18 nm; in the high temperature growth step S13, a laser power at the point of target irradiation was 0.93 W and a substrate temperature was 760 °C. The layer was grown to a thickness of about 300 nm. A growth rate was about 300 nm/hr. The resulting layer was evaluated as described in Example A-1. Table 1 shows the growth conditions and Table 2 shows the evaluation results for the film obtained.

Example A-4

Deposition was conducted as described in Example A-1, except that in the low temperature deposition step S12, a RF radical source as a nitrogen source was used at 400 W, a substrate temperature was room temperature, a laser power at the point of target irradiation was 0.41 W, a growth rate was 157 nm/hr, a growth film thickness was 26 nm; and in the high temperature growth step S13, a laser power at the point of target irradiation was 0.97 W. The layer was grown to a thickness of about 300 nm. A growth rate was about 300 nm/hr. The resulting layer was evaluated as described in Example A-1. Table 1 shows the growth conditions and Table 2 shows the evaluation results for the film obtained.

Example A-5

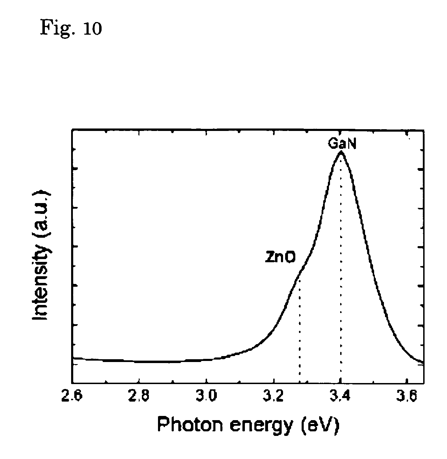

Deposition was conducted as described in Example A-1, except that in the low temperature deposition step S12, a RF radical source as a nitrogen source was used at 400 W, a substrate temperature was room temperature, a laser power at the point of target irradiation was 0.41 W, a growth rate was 102 nm/hr, a growth film thickness was 17 nm; and in the high temperature growth step S13, a laser power at the point of target irradiation was 0.93 W. The layer was grown to a thickness of about 300 nm. A growth rate was about 300 nm/hr. The resulting layer was evaluated as described in Example A-1. Table 1 shows the growth conditions and Table 2 shows the evaluation results for the film obtained. Furthermore, FIG. 10 shows the results of photoluminescence measurement for the GaN layer obtained. Although the luminescence is the emission from a thin crystal layer with a thickness of about 300 nm, it has a larger luminescence intensity than a luminescence from the substrate ZnO, indicating optically excellent crystallinity.

Example A-6

Deposition was conducted as described in Example A-1, except that in the low temperature deposition step S12, a RF radical source as a nitrogen source was used at 400 W, a substrate temperature was room temperature, a laser power at the point of target irradiation was 0.46 W, a growth rate was 195 nm/hr, a growth film thickness was 100 nm; and in the high temperature growth step S13 a laser power at the point of target irradiation was 0.83 W. The layer was grown to a thickness of about 300 nm. A growth rate was about 300 nm/hr. The resulting layer was evaluated as described in Example A-1. Table 1 shows the growth conditions and Table 2 shows the evaluation results for the film obtained.

Example A-7

The planarization step S11 in Example A-1 was conducted, except that a planarization temperature in the planarization step S11 was 1050 °C.
Next, in the low temperature deposition step S12, deposition was conducted as described for the low temperature deposition step S12 in Example A-1, except that a RF radical source was used at 400 W, a growth pressure was $6.0 \times 10^{-6}$ Torr, a substrate temperature was room temperature, a laser power at the point of target irradiation was 0.30 W, a growth rate was 150 nm/hr and a growth film thickness was 40 nm.
Next, in the high temperature deposition step S13 (the second sub-growing step), deposition of an AlN layer was conducted as described for the high temperature deposition step S13 in the Example A-1, except that the target 32 was Al metal, a RF radical source was used at 320 W, a growth pressure was $4.5 \times 10^{-6}$ Torr, a pulse frequency of a pulse laser beam was 30 Hz, a laser power at the time of target irradiation was 0.64 W and a substrate temperature was 750 °C. The layer was grown to a film thickness of about 50 nm. A growth rate was about 100 nm/hr.
The AlN layer thus obtained was evaluated as described in Example A-1. Table 1 shows the growth conditions and Table 2 shows the evaluation results for the film obtained.

Example A-8

A ZnO substrate planarized as described in Example A-1 was introduced into the apparatus, then in the low temperature deposition step S12 (the first sub-growing step) deposition was conducted as described for the low temperature deposition step S12 in Example A-1, except that the a RF radical source was used at 320 W, a deposition pressure was $2.0 \times 10^{-5}$ Torr, a substrate temperature was room temperature, a pulse frequency of a pulse laser beam was 15 Hz, a laser power at the point of target irradiation was 0.08 W, a growth rate was 60 nm/hr and a growth film thickness was 10 nm.
Next, in the high temperature deposition step S13 (the second sub-growing step), an InN layer was deposited as described for the high temperature deposition step S13 in the Example A-1, except that the target 32 was In metal, a RF radical source was used at 320 W, a growth pressure was $2.0 \times 10^{-5}$ Torr, a pulse frequency of a pulse laser beam was 10 Hz, a laser power at the point of target irradiation was 0.15 W and a substrate temperature was 500 °C. The layer was grown to a film thickness of about 150 nm. A growth rate was about 150 nm/hr.
The InN layer thus obtained was evaluated as described in Example A-1. Table 1 shows the growth conditions and Table 2 shows the evaluation results for the film obtained.

Example A-9

A ZnO substrate planarized as described in Example A-1 was introduced into the apparatus, then in the low temperature deposition step S12, an InN layer was deposited as described for the low temperature deposition step S12 in Example A-1, except that a target 32 was In metal, a RF radical source was used at 320 W, a deposition pressure was $2.0 \times 10^{-5}$ Torr, a pulse frequency of a pulse laser beam was 10 Hz, a laser power at the point of target irradiation was 0.15 W and a substrate temperature was 300 °C.
Next, in the high temperature deposition step S13 (the second sub-growing step), an InN layer was deposited as described for the high temperature deposition step S13 in the Example A-1, except that the target 32 was In metal, a RF radical source was used at 320 W, a growth pressure was $2.0 \times 10^{-5}$ Torr, a pulse frequency of a pulse laser beam was 10 Hz, a laser power at the point of target irradiation was 0.15 W and a substrate temperature was 500 °C. The layer was grown to a film thickness of about 150 nm. A growth rate was about 150 nm/hr.
The InN layer thus obtained was evaluated as described in Example A-1. Table 1 shows the growth conditions and Table 2 shows the evaluation results for the film obtained.

Comparative Example A-1: an example in which deposition of a low temperature growth layer was conducted at a high temperature

A ZnO substrate 11 as described in Example A-3 was introduced in a PLD apparatus and a first GaN layer 13 was deposited in the low temperature deposition step S12. In the low temperature deposition step S12, a laser power of a pulse laser beam outgoing from the KrF excimer laser 33 at the point of target irradiation was 0.40 W. A substrate temperature of the ZnO substrate 11 was 500 °C and a growth film thickness was 10 nm. The other conditions were as described for the low temperature deposition step S12 in Example A-3. Then, in the high temperature deposition step S13, a second GaN layer 14 was deposited. In the high temperature deposition step S13, a laser power of a pulse laser beam outgoing from the KrF excimer laser 33 at the point of target irradiation was 0.48 W and a substrate temperature of the ZnO substrate 11 was 680 °C. The other conditions were as described for the high temperature deposition step S13 in Example A-3. Table 1 shows the growth conditions and Table 2 shows the evaluation results for the film obtained.

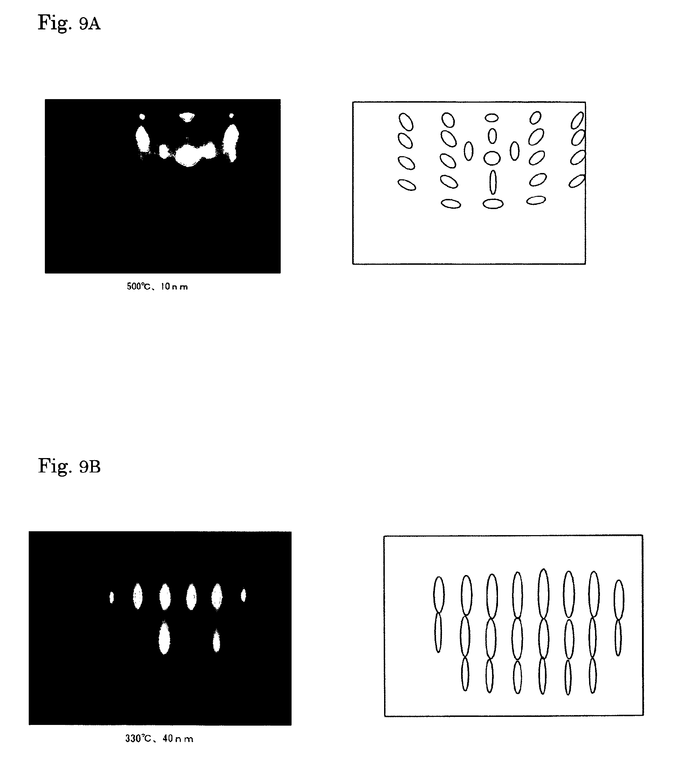

FIG. 9A shows a RHEED image where the first layer was formed to a film thickness of 10 nm. The RHEED image in FIG. 9A indicates that the GaN layer is multicrystalline, having significantly poor crystallinity.

Comparative Example A-2: an example in which no low temperature growth layer was formed

A ZnO substrate 11 as described in Example A-3 was introduced in a PLD apparatus and without depositing a first GaN layer 13 in the low temperature deposition step S12, a second GaN layer 14 was deposited in the high temperature deposition step S13. In the high temperature deposition step S13, a laser power of a pulse laser beam outgoing from the KrF excimer laser 33 at the point of target irradiation was controlled within the range of 0.30 to 0.48 W and a substrate temperature of the ZnO substrate 11 was 700 °C. The other conditions were as described for the high temperature deposition step S13 in Example A-3. Table 1 shows the growth conditions and Table 2 shows the evaluation results for the film obtained.

Comparative Example A-3: an example in which growth rate of a low temperature growth layer was high

Deposition was conducted as described in Example A-1, except that in the low temperature deposition step S12, a RF radical source as a nitrogen source was used at 400 W, a laser power at the point of target irradiation was 0.59 W, a growth rate was 300 nm/hr, a growth film thickness was 20 nm and in the high temperature growth step S13, a substrate temperature was 705 °C and a laser power at the point of target irradiation was 0.84 W. The layer was grown to a film thickness of about 300 nm. A growth rate was about 300 nm/hr. The layer obtained was evaluated as described in Example A-1. Table 1 shows the growth conditions and Table 2 shows the evaluation results for the film obtained.

Comparative Example A-4: an example in which only a low temperature growth layer was formed

A ZnO substrate 11 as described in Example A-3 was introduced in a PLD apparatus, and in the low temperature deposition step S12, only a first GaN layer 13 was deposited. The deposition of a second GaN layer 14 in the high temperature deposition step S13 was not conducted. In the low temperature deposition step S12, a pulse frequency of a pulse laser beam outgoing from the KrF excimer laser 33 was 10 Hz and a laser power at the point of target irradiation was 0.1 W. Furthermore, a substrate temperature of the ZnO substrate 11 was 330 °C and a growth film thickness was 40 nm. FIG. 9B shows a RHEED image of the film obtained. It can be found that flatness is less than FIG. 8C.

Table 1: Growth conditions

| | First sub-growing step (Low temperature growth step) | | | | | Second sub-growing step (High temperature growth step) | | | |
|---|---|---|---|---|---|---|---|---|---|
| | Substrate temperature (°C) | Laser output (W) | pulse frequency (Hz) ) | Growt h rate (nm/hr | Film thickness (nm) | Substrate temperature (°C) | Laser output (W) | Pulse frequency (Hz) | Film thickness (nm) |
| Example A-1 | 300 | 0.36 | 30 | 47 | 12 | 700 | 0.86 | 50 | c.a. 300 |
| Example A-2 | 320 | 0.36 | 30 | 53 | 13 | 690 | 0.93 | 50 | c.a.300 |
| Example A-3 | 310 | 0.42 | 30 | 107 | 18 | 760 | 0.93 | 50 | c.a.300 |
| Example A-4 | 320 | 0.41 | 30 | 157 | 26 | 700 | 0.97 | 50 | c.a. 300 |
| Example A-5 | RT | 0.41 | 30 | 102 | 17 | 700 | 0.93 | 50 | c.a.300 |
| Example A-6 | RT | 0.49 | 30 | 195 | 100 | 700 | 0.83 | 50 | c.a. 300 |
| Example A-7 | RT | 0.30 | 30 | 150 | 40 | 750 | 0.64 | 30 | c.a.50 |
| Example A-8 | RT | 0.08 | 15 | 60 | 10 | 500 | 0.15 | 10 | c.a. 150 |
| Example A-9 | 300 | 0.15 | 10 | 150 | 150 | 500 | 0.15 | 10 | c.a. 150 |
| Comparative Example A-1 | 500 | 0.40 | 30 | - | c.a. 10 | 680 | 0.48 | 30 | c.a. 100 |
| Comparative Example A-2 | - | - | - | - | - | 700 | 0.41 | 30 | c.a. 100 |
| Comparative Example A-3 | 300 | 0.59 | 30 | 300 | 20 | 705 | 0.84 | 50 | c.a. 300 |

Table 2: Evaluation results

| | $a_1$ | $a_2$ | $b_1$ | $b_2$ | $b_3$ | $b_4$ | V/III ratio |
|---|---|---|---|---|---|---|---|
| Example A-1 | 0.021 | 0.103 | 0.122 | | 0.084 | 0.085 | 11.7 |
| Example A-2 | 0.027 | 0.110 | 0.105 | 0.091 | 0.078 | 0.102 | 10.4 |
| Example A-3 | 0.040 | 0.274 | 0.120 | | 0.083 | 0.223 | 5.1 |
| Example A-4 | 0.069 | 0.207 | 0.250 | | 0.140 | 0.168 | 5.4 |
| Example A-5 | 0.052 | 0.110 | 0.136 | 0.135 | 0.116 | 0.146 | 5.4 |
| Example A-6 | 0.214 | 0.218 | 0.206 | | 0.149 | 0.277 | 2.8 |
| Example A-7 | 0.13 | 0.32 | | | | | |
| Example A-8 | | 0.80 | 0.36 | 0.49 | | | |
| Example A-9 | | 0.52 | 0.30 | 0.17 | | | |
| Comparative Example A-1 | 0.700 | 0.580 | 0.970 | | | | |
| Comparative Example A-2 | 1.560 | 0.680 | | 1.10 | | | |
| Comparative Example A-3 | 0.401 | 0.382 | Unmeasurable because of a low reflection intensity due to deteriorated crystallinity | | | | 1.8 |

Reference Experiments

A GaN was grown on a c-plane ZnO substrate under the conditions in Example A-5. Furthermore, a GaN was grown on a m-plane ZnO and a c-plane ZnO under the conditions rich in atomic nitrogen radicals. Table 3 shows the evaluation results for the films obtained.
Table 3: Growth-plane orientation

| Twist evaluation by XRC measurement Evaluated plane: (10-12) plane*) | | |
|---|---|---|
| Growth-plane orientation | Main constituents in nitrogen excited species | |
| | Atomic radical | Molecular radical |
| c-plane | 0.39 | 0.59 |
| m-plane | 0.47 | 0.146 (Example A-5) |
| *) corresponding to $b_4$ for m-plane | | |

The results demonstrate that excited species that contribute crystal growth of a high quality thin film are entirely different between c-plane as a polar plane and m-plane as a nonpolar plane. Furthermore, it is demonstrated that a thin film with particularly favorable crystallinity is obtained in m-plane.
There will be described examples of a-plane growth.

Reference Example B-1

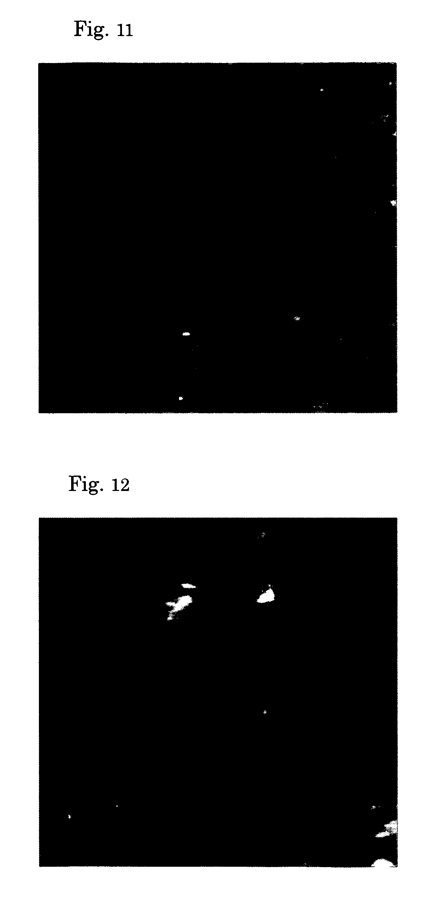

The surface of a ZnO substrate having a-plane as a principal surface was processed by CMP (chemical mechanical polishing). FIG. 11 shows an atomic force microscopy image (AFM image) of this substrate. A surface roughness in the full visual field was as follows.
Ra = 0.177 nm

RMS = 0.226 nm

Reference Example B-2

A substrate processed as described in Reference Example B-1 was annealed at 700 °C for 10 hours. FIG. 12 shows an atomic force microscopy image (AFM image) of this substrate. A surface roughness in the full visual field was as follows.
Ra = 0.275 nm
RMS = 0.346 nm

Reference Example B-3

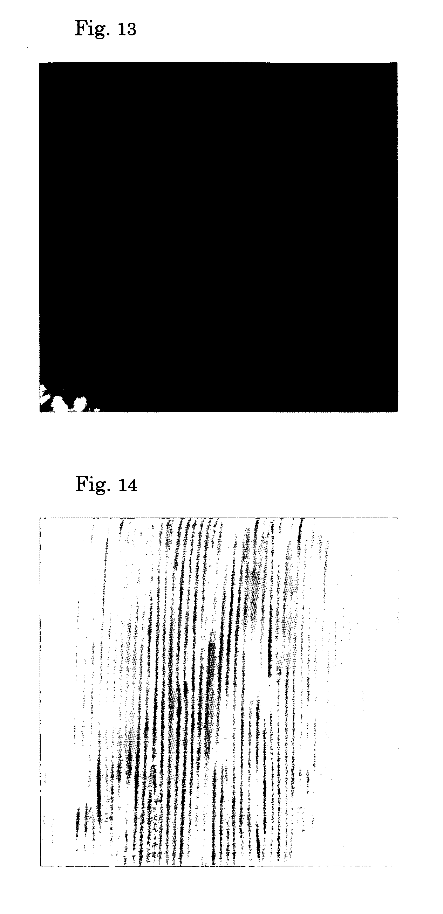

A substrate processed as described in Reference Example B-1 was annealed at 850 °C for 10 hours. FIG. 13 shows an atomic force microscopy image (AFM image) of this substrate. A surface roughness in the full visual field was as follows.
Ra = 0.891 nm
RMS = 1.28 nm

Reference Example B-4

A substrate processed as described in Reference Example B-1 was annealed at 950 °C for 10 hours. FIG. 14 shows an atomic force microscopy image (AFM image) of this substrate. A surface roughness in the full visual field was as follows.
Ra = 1.65 nm
RMS = 2.10 nm

Reference Example B-5

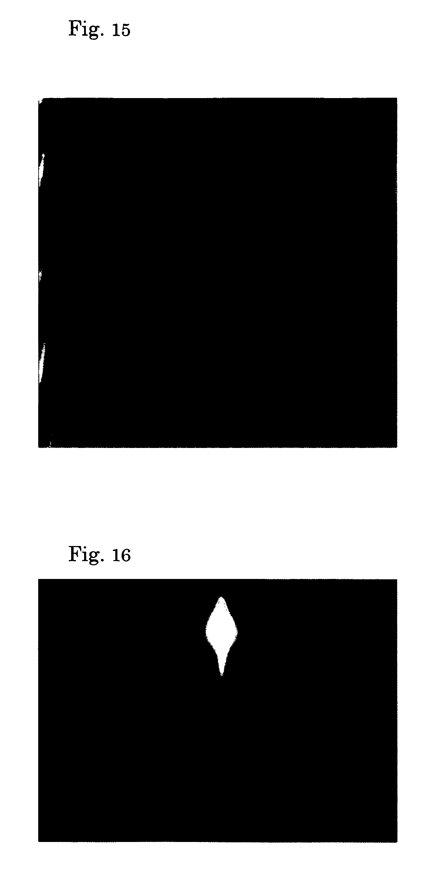

A substrate processed as described in Reference Example B-1 was annealed at 1150 °C for 6 hours. FIG. 15 shows an atomic force microscopy image (AFM image) of this substrate. In the substrate surface, a stripe texture can be clearly observed. A surface roughness in the full visual field was as follows.
Ra = 3.07 nm
RMS = 3.73 nm

Example B-1

A ZnO substrate 11 having a-plane as a principal surface as described in Reference Example B-1 was introduced in a PLD apparatus, and as the first sub-growing step, a GaN layer as the first layer was deposited. The target 32 was made of Ga metal (purity: 99.99 %). The target 32 was placed in parallel with a-plane of the ZnO substrate 11. A RF radical source was used as a nitrogen source at 400 W, and a growth pressure was $4.5 \times 10^{-6}$ Torr.
A pulse frequency of a pulse laser beam outgoing from a KrF excimer laser 33 was 20 Hz, an irradiation time per 1 pulse was 20 ns, and a laser power at the point of target irradiation was 0.28 W. A substrate temperature of the ZnO substrate 11 was room temperature and the layer was grown to a thickness of 4 nm. A growth rate was 30 nm/hr.
In this growth process, the RHEED image shows a distinct two-dimensional diffraction streak pattern as shown in FIG. 16, indicating that the GaN layer was grown while maintaining single crystal having a very flat growth-plane from the initial growth stage.
Subsequently, as the second sub-growing step, a GaN layer 14 as a second layer was deposited. The target 32 was made of Ga metal (purity: 99.99 %). The target 32 was placed in parallel with a-plane of the ZnO substrate 11. A RF radical source was used as a nitrogen source at 400 W, and a growth pressure was $4.5 \times 10^{-6}$ Torr. A pulse frequency of a pulse laser beam outgoing from the KrF excimer laser 33 was 50 Hz and a laser power at the point of target irradiation was 0.73 W. A substrate temperature of the ZnO substrate 11 was 675 °C. The layer was grown to a film thickness of about 230 nm. A growth rate was about 300 nm/hr.
The GaN layer thus obtained as a sample was evaluated for its crystal mosaic structure by X-ray rocking curve measurement. Table 4 shows the growth conditions and Table 5 shows the evaluation results for the film obtained.

Examples B-2 to B-4

Example B-1 was repeated, except employing the growth conditions shown in Table 4. Table 5 shows the evaluation results for the film obtained.

Comparative Example B-1

Example B-1 was repeated by using a ZnO substrate having a-plane as a principal surface processed as described in Reference Example B-5, except that the growth conditions shown in Table 4 were employed. Table 5 shows the evaluation results for the film obtained.
Table 4: Growth conditions

|  | ZnO-substrate Annealing | First sub-growing step | | | | | Second sub-growing step | | | | |
|---|---|---|---|---|---|---|---|---|---|---|---|
|  | Annealing temperature (°C) | Substrate temperature (°C) | Laser output (W) | Pulse frequency (Hz) | Time (min) | Film thickness (nm) | Substrate temperature (°C) | Laser output (W) | Pulse frequency (Hz) | Time (min) | Film thickness (nm) |
| Example B-1 | None | RT | 0.28 | 20 | 8 | 4 | 675 | 0.73 | 50 | 45 | 230 |
| Example B-2 | None | RT | 0.38 | 30 | 10 | 7.5 | 710 | 0.73 | 50 | 60 | 300 |
| Example B-3 | None | RT | 0.44 | 30 | 10 | 5 | 610 | 0.86 | 50 | 60 | 300 |
| Example B-4 | None | RT | 0.42 | 30 | 10 |  | 730 | 1.09 | 50 | 60 |  |
| Comparative Example B-1 | 1150 | RT | 0.4 | 30 | 20 |  | 710 | 1.00 | 50 | 60 |  |

Table 5: Evaluation results

|  | $a_1$ | $a_2$ | $b_1$ |
|---|---|---|---|
| Example B-1 | 0.04 | 0.68 | 0.23 |
| Example B-2 | 0.06 | 0.64 | 0.09 |
| Example B-3 | 0.13 | 0.50 | 0.19 |
| Example B-4 | 0.10 | 0.44 | 0.20 |
| Comparative Example B-1 | 0.52 | 0.36 | 1.05 |

There will be described an example of (12-30) plane growth.

Example C-1

A ZnO substrate 11 having (12-30) plane as a principal surface as described in Reference Example B-1 was introduced in a PLD apparatus, and as the first sub-growing step, a GaN layer as the first layer was deposited. The target 32 was made of Ga metal (purity: 99.99 %). The target 32 was placed in parallel with (12-30) plane of the ZnO substrate 11. A RF radical source was used as a nitrogen source at 400 W, and a growth pressure was $6.0 \times 10^{-6}$ Torr.
A pulse frequency of a pulse laser beam outgoing from a KrF excimer laser 33 was 30 Hz, an irradiation time per 1 pulse was 20 ns, and a laser power at the point of target irradiation was 0.29 W. A substrate temperature of the ZnO substrate 11 was room temperature and the layer was grown to a thickness of 10 nm. A growth rate was 60 nm/hr.
Subsequently, as the second sub-growing step, a GaN layer 14 as a second layer was deposited. The target 32 was made of Ga metal (purity: 99.99 %). The target 32 was placed in parallel with a plane of the ZnO substrate 11. A RF radical source was used as a nitrogen source at 400 W, and a growth pressure was $6.0 \times 10^{-6}$ Torr. A pulse frequency of a pulse laser beam outgoing from the KrF excimer laser 33 was 50 Hz and a laser power at the point of target irradiation was 0.92 W. A substrate temperature of the ZnO substrate 11 was 670 °C. The layer was grown to a film thickness of about 400 nm. A growth rate was about 400 nm/hr.
The GaN layer thus obtained as a sample was evaluated for its crystal mosaic structure by X-ray rocking curve measurement. Table 6 shows the growth conditions and Table 7 shows the evaluation results for the film obtained.

Table 6: Growth conditions

|  | ZnO substrate annealing | First sub-growing step | | | | | Second sub-growing step | | | | |
|---|---|---|---|---|---|---|---|---|---|---|---|
|  | Annealing temperature (°C) | Substrate temperature (°C) | Laser output (W) | Pulse frequency (Hz) | Time (min) | Film thickness (nm) | Substrate temperature (°C) | Laser output (W) | Pulse frequency (Hz) | Time (min) | Film thickness (nm) |
| Example C-1 | None | RT | 0.29 | 30 | 10 | 10 | 670 | 0.92 | 50 | 60 | 400 |
| Substrate plane orientation: (12-30) plane | | | | | | | | | | | |

Table 7

| | Growth-plane orientation | $a_1$ | $a_2$ | $b_1$ | $b_2$ | $b_3$ | $b_4$ |
|---|---|---|---|---|---|---|---|
| Example C-1 | (12-30) | 0.093 | 0.625 | | | 0.200 | |

**Claims**

1. A Group III-V nitride layer belonging to hexagonal crystal formed by growing on a substrate having a different lattice constant, with the proviso that a substrate containing either Li or C as a principal constituent element is excluded, wherein the Group III-V nitride layer satisfies at least one of the following conditions (i) to (iv):

    (i) a growth-plane is a plane perpendicular to {0001} (hereinafter, referred to as a "nonpolar plane") and a full width at half maximum $b_1$ of angle dependence of X-ray diffraction intensity in a plane perpendicular to the growth-plane and parallel to c-axis [0001], upon X ray incident angle from a direction parallel to the growth-plane, satisfies the condition of $0.01° \leq b_1 \leq 0.5°C$
    (ii) a growth-plane is a nonpolar plane and a full width at half maximum $b_2$ of angle dependence of a X-ray diffraction intensity in {0001}plane, upon X-ray incident angle from a direction parallel to the growth-plane, satisfies the condition of $0.01° \leq b_2 \leq 0.5°$;
    (iii) a growth-plane is a nonpolar plane, and when a diffraction plane is {1-100}plane or {11-20}plane which forms an angle of 60° or more and less than 90° with the growth-plane, a full width at half maximum $b_3$ of angle dependence of X-ray diffraction intensity in the diffraction plane, upon X-ray incident angle from a direction parallel to a plane perpendicular to the diffraction plane and parallel to c-axis [0001], satisfies the condition of $0.01° \leq b_3 \leq 0.5°$; and
    (iv) a growth-plane is a nonpolar plane and when, assuming that the growth-plane orientation is represented by {ijk0} a diffraction plane is {ijk2}plane tilted from the growth-plane only to [0001] and [000-1] directions, a full width at half maximum $b_4$ of angle dependence of X-ray diffraction intensity in the diffraction plane, upon X-ray incident angle from a direction parallel to a plane formed by tilting {0001} plane by an angle equal to a tilt angle from the growth-plane to the diffraction plane in the same direction, satisfies the condition of $0.01° \leq b_4 \leq 0.5°$.

2. A Group III-V nitride layer belonging to hexagonal crystal formed by growing on a substrate having a different lattice constant, with the proviso that a substrate containing either Li or C as a principal constituent element is excluded, wherein the growth-plane is a nonpolar plane and a full width at half maximum $a_1$ of angle dependence of X-ray diffraction intensity in the growth-plane, upon X-ray incident angle from a direction parallel to a plane perpendicular to the growth-plane and parallel to c-axis [0001], satisfies the condition of $0.01° \leq a_1 \leq 0.25°$.

3. The Group III-V nitride layer as claimed in Claim 2, wherein a full width at half maximum $a_1$ satisfies the condition of $0.01° \leq a_1 \leq 0.15°$.

4. The Group III-V nitride layer as claimed in any of Claims 1 to 3, wherein a thickness T (nm) satisfies the condition of 5 nm$\leq$ T$\leq$ 10000 nm.

5. The Group III-V nitride layer as claimed in Claim 4, wherein a thickness T (nm) satisfies the condition of 5 nm$\leq$ T$\leq$ 500 nm.

6. The Group III-V nitride layer as claimed in any of Claims 1 to 5, wherein the growth-plane is a nonpolar plane, and a full width at half maximum $a_2$ of angle dependence of X diffraction intensity of the growth-plane, upon X-ray incident angle from a direction perpendicular to c-axis [0001], satisfies the condition of $0.05° \leq a_2 \leq 0.5°$.

7. The Group III-V nitride layer as claimed in any of Claims 1 to 6, wherein the substrate has a crystal structure belonging to hexagonal crystal, and a nominal plane orientation of the substrate is identical to a growth-plane orientation a Group III-V nitride layer to be grown.

8. The Group III-V nitride layer as claimed in any of Claims 1 to 7, wherein the substrate is ZnO.

9. The Group III-V nitride layer as claimed in Claim 8, wherein the substrate is a ZnO substrate having a plane with a surface roughness Ra of 3 nm or less.

10. The Group III-V nitride layer as claimed in Claim 8, wherein the substrate is a ZnO substrate having, as a principal surface, m-plane annealed at a high temperature of 800 °C or higher.

11. The Group III-V nitride layer as claimed in Claim 8, wherein the substrate is a ZnO substrate having, as a principal surface, a nonpolar plane other than m-plane annealed at a temperature of less than 1150 °C or not annealed.

12. The Group III-V nitride layer as claimed in any of Claims 1 to 11, comprising at least Ga and N as constituent elements.

13. The Group III-V nitride layer as claimed in Claim 12, comprising a GaN layer.

14. The Group III-V nitride layer as claimed in any of Claims 1 to 13, comprising at least
a first layer formed at a growth temperature of less than 500 °C, directly on the substrate, and
a second layer formed on the first layer at a growth temperature of 400 °C or higher and higher than the growth temperature of the first layer.

15. The Group III-V nitride layer as claimed in Claim 14, wherein the first layer is formed at a growth temperature of 450 °C or lower and the second layer is formed at a growth temperature of 400 to 1300 °C.

16. The Group III-V nitride layer as claimed in Claim 14 or 15, wherein the first layer has a thickness of less than 500 nm.

17. The Group III-V nitride layer as claimed in any of Claims 1 to 16, wherein the Group III-V nitride layer is formed by a method in which, on the growth-plane of the layer, the Group III element is intermittently supplied and the Group V element is supplied in a form containing radicals.

18. The Group III-V nitride layer as claimed in Claim 17, wherein the Group III-V nitride layer is formed by a method in which, on the growth-plane of the layer, the Group III element is intermittently supplied and the Group V element is supplied in a form containing molecular nitrogen radicals.

19. The Group III-V nitride layer as claimed in any of Claims 1 to 18, wherein the Group III element is supplied in a form of metal.

20. The Group III-V nitride layer as claimed in any of Claims 1 to 19, formed by pulse laser deposition.

21. A laminated structure comprising the Group III-V nitride layer as claimed in any of Claims 1 to 20 and an additional layer formed over the layer.

22. The laminated structure as claimed in Claim 21, wherein the additional layer comprises a layer which is lattice-matched with the Group III-V nitride layer.

23. The laminated structure as claimed in Claim 21 or 22, wherein the additional layer is formed by a deposition process selected from the group consisting of VPE, CVD, MBE, sputtering, evaporation and a combination of two or more of these.

24. A process for growing a Group III-V nitride layer belonging to hexagonal crystal on a substrate having a different lattice constant, with the proviso that a substrate containing Li as a principal constituent element is excluded, the process comprising steps of:

   (a) providing a substrate having, as a principal surface, a hexagonal nonpolar plane or a plane having a lattice structure identical to that of the hexagonal nonpolar plane,
   (b) growing the Group III-V nitride layer on the principal surface of the substrate at least in two steps, comprising
   (b-1) a first sub-growing step of growing a first layer on the principal surface of the substrate at a growth temperature of lower than 500 °C while maintaining a single crystal structure on the growth-plane, and
   (b-2) a second sub-growing step of growing a second layer on the first layer at a growth temperature of 400 °C or higher and higher than the growth temperature in the first sub-growing step.

25. The process as claimed in Claim 24, wherein in the first sub-growing step, the first layer is formed at a growth temperature of 450 °C or lower and in the second sub-growing step, the second layer is formed at a growth temperature of 400 to 1300 °C.

**26.** The process as claimed in Claim 24 or 25, wherein a growth rate of the first layer in the first sub-growing step was selected from the range of more than 10 nm/hr and less than 300 nm/hr, and a growth rate of the second layer in the second sub-growing step is selected from the range of 30 nm/hr to 5000 nm/hr.

**27.** The process as claimed in Claim 26, wherein a growth rate of the second layer in the second sub-growing step is selected from the range of 120 nm/hr to 5000 nm/hr.

**28.** The process as claimed in any of Claims 24 to 27, wherein in the first sub-growing step, the Group III element is intermittently supplied to the growth-plane and the Group V element is supplied in a form containing radicals.

**29.** The process as claimed in Claim 28, wherein in the first sub-growing step, the Group III element is intermittently supplied to the growth-plane and the Group V element is supplied in a form containing molecular nitrogen radicals.

**30.** The process as claimed in Claim 28 or 29, wherein in the first sub-growing step, stop period of the intermittent supply of the Group III element is selected from the range of 1 m sec to 10 sec.

**31.** The process as claimed in any of Claims 28 to 30, wherein in the second sub-growing step, the Group III element is intermittently supplied to the growth-plane and the Group V element is supplied in a form containing radicals.

**32.** The process as claimed in Claim 31, wherein in the second sub-growing step, the Group III element is intermittently supplied to the growth-plane and the Group V element is supplied in a form containing molecular nitrogen radicals.

**33.** The process as claimed in any of Claims 24 to 32, wherein in the first sub-growing step, the first layer is grown by pulse laser deposition.

**34.** The process as claimed in any of Claims 24 to 33, wherein the Group III element is supplied as a metal.

**35.** The process as claimed in any of Claims 24 to 34, wherein in the first sub-growing step, the first layer is grown such that its thickness is less than 500 nm.

**36.** The process as claimed in any of Claims 24 to 35, wherein the substrate is a ZnO substrate having a plane with a surface roughness Ra of 3 nm or less.

**37.** The process as claimed in any of Claims 24 to 35, wherein the substrate is a ZnO substrate having, as a principal surface, m-plane, which is annealed at a high temperature of 800 °C or higher.

**38.** The process as claimed in any of Claims 24 to 35, wherein the substrate is a ZnO substrate having, as a principal surface, a nonpolar plane other than m-plane annealed at a temperature of less than 1150 °C or not annealed.

**39.** The process as claimed in any of Claims 24 to 38, wherein the conditions are selected such that the Group III-V nitride layer as claimed in any of Claims 1 to 6 is formed.

**40.** A process for manufacturing a laminated structure comprising further depositing, on the Group III-V nitride layer formed by the process as claimed in any of Claims 24 to 39, an additional layer comprising at least a lattice-matched layer by a deposition process selected from the group consisting of VPE, CVD, MBE, sputtering, evaporation and a combination of two or more of these.

**41.** A Group III-V nitride layer belonging to hexagonal crystal formed by growing on a substrate having a different lattice constant,
wherein
the substrate is a ZnO substrate having a nonpolar plane as a principal surface,
is grown by pulse laser deposition where a Group III element and nitrogen radicals are supplied, and
has a composition represented by $In_xAl_yGa_{(1-x-y)}N$ wherein x and y are numbers satisfying the conditions of $0 \leq x \leq 1$, $0 \leq y \leq 1$ and $0 \leq x+y \leq 1$, and
wherein at least one of the following conditions (i) to (v) is met:

> (i) a growth-plane is a plane perpendicular to {0001} (hereinafter, referred to as a "nonpolar plane") and a full width at half maximum $b_1$ of angle dependence of X-ray diffraction intensity in a plane perpendicular to the growth-plane and parallel to c-axis [0001] upon X ray incident angle from a direction parallel to the growth-plane satisfies the condition of $0.01° \leq b_1 \leq 0.5°$;

(ii) a growth-plane is a nonpolar plane and a full width at half maximum $b_2$ of angle dependence of a X-ray diffraction intensity in {0001}plane upon X-ray incident angle from a direction parallel to the growth-plane satisfies the condition of $0.01° \leq b_2 \leq 0.5°$;

(iii) a growth-plane is a nonpolar plane, and when a diffraction plane is {1-100}plane or {11-20}plane which forms an angle of 60° or more and less than 90° with the growth-plane, a full width at half maximum $b_3$ of angle dependence of X-ray diffraction intensity in the diffraction plane upon X-ray incident angle from a direction parallel to a plane perpendicular to the diffraction plane and parallel to c-axis [0001] satisfies the condition of $0.01° \leq b_3 \leq 0.5°$;

(iv) a growth-plane is a nonpolar plane and when, assuming that the growth-plane orientation is represented by {ijk0}, a diffraction plane is {ijk2}plane tilted from the growth-plane only to [0001] and [000-1] directions, a full width at half maximum $b_4$ of angle dependence of X-ray diffraction intensity in the diffraction plane upon X-ray incident angle from a direction parallel to a plane formed by tilting {0001}plane by an angle equal to a tilt angle from the growth-plane to the diffraction plane in the same direction satisfies the condition of $0.01° \leq b_4 \leq 0.5°$; and

(v) a growth-plane is a nonpolar plane and a full width at half maximum $a_1$ of angle dependence of X-ray diffraction intensity of the growth-plane upon X-ray incident angle from a direction parallel to a plane perpendicular to the growth-plane and parallel with c-axis [0001] satisfies the condition of $0.01° \leq a_1 \leq 0.25°$.

42. A laminated structure comprising
the Group III-V nitride layer as claimed in Claim 41; and
an additional layer which is lattice-matched with the Group III-V nitride layer and is formed, on the layer, by a deposition process selected from the group consisting of VPE, CVD, MBE, sputtering, evaporation and a combination of two or more of these.

43. A process for growing a Group III-V nitride layer belonging to hexagonal crystal on a substrate having a different lattice constant, with the proviso that a substrate containing Li as a principal constituent element is excluded, the process comprising growing steps of:

(a) providing a substrate having a hexagonal nonpolar plane or a plane having a lattice structure identical to that of the hexagonal nonpolar plane,
(b) growing the Group III-V nitride layer on the principal surface of the substrate at least in two steps, comprising
(b-1) a first sub-growing step of growing a first layer on the principal surface of the substrate at a growth temperature of lower than 500 °C and a growth rate of more than 10 nm/hr and less than 300 nm/hr, and
(b-2) a second sub-growing step of growing a second layer on the first layer at a growth temperature of 400 °C or higher and higher than the growth temperature in the first sub-growing step.

44. A process for growing a Group III-V nitride layer belonging to hexagonal crystal on a substrate having a different lattice constant, with the proviso that a substrate containing Li as a principal constituent element is excluded, the process comprising growing steps of:

(a) providing a substrate having a hexagonal nonpolar plane or a plane having a lattice structure identical to that of the hexagonal nonpolar plane,
(b) growing the Group III-V nitride layer on the principal surface of the substrate at least in two steps, comprising
(b-1) a first sub-growing step of growing a first layer on the principal surface of the substrate at a growth temperature of lower than 500 °C while intermittently supplying a Group III element with a supply stop period in the range of 0.001 sec to 10 sec, and
(b-2) a second sub-growing step of growing a second layer on the first layer at a growth temperature of 400 °C or higher and higher than the growth temperature in the first sub-growing step.

45. A process for growing a Group III-V nitride layer belonging to hexagonal crystal on a substrate having a different lattice constant, with the proviso that a substrate containing Li as a principal constituent element is excluded, the process comprising the growing steps of:

(a) providing a substrate having a hexagonal nonpolar plane or a plane having a lattice structure identical to that of the hexagonal nonpolar plane,
(b) growing the Group III-V nitride layer on the principal surface of the substrate at least in two steps, comprising

(b-1) a first sub-growing step of growing a first layer on the principal surface of the substrate at a growth temperature of lower than 500 °C and a growth rate of more than 10 nm/hr and less than 300 nm/hr while intermittently supplying a Group III element with a supply stop period in the range of 0.001 sec to 10 sec, and (b-2) a second sub-growing step of growing a second layer on the first layer at a growth temperature of 400 °C or higher and higher than the growth temperature in the first sub-growing step.

Fig. 1

Plan view

Fig. 2

Rotation axis of crystal

X-ray
incident angle

2 θ

ω

X-ray
generator

Crystal plane
orientation

X-ray detector

Fig. 3

[1-100] axis    GaN (high temperature deposition)    ← 14

[1-100] axis    GaN (low temperature deposition)    ← 13

{1-100} plane and its equivalent planes

ZnO substrate    ← 11

12

10

Fig. 4

Planarization of a ZnO substrate    ← S11

Low temperature deposition of a GaN layer    ← S12

High temperature deposition of a GaN layer    ← S13

Fig. 5

Fig. 6

Second GaN layer
(high temperature
growth layer)

First GaN layer
(low temperature
growth layer)

ZnO substrate

Fig. 7A

Processed at 1250 °C for 3.5 hours

Fig. 7B

Not planarized

Fig. 8A

(ZnO substrate)

Fig. 8B

After growing the first layer for two minutes

Fig. 8C

After growing the first layer for ten minutes

Fig. 9A

500°C、10n m

Fig. 9B

330°C、40n m

Fig. 10

Fig. 11

Fig. 12

Fig. 13

Fig. 14

Fig. 15

Fig. 16

## INTERNATIONAL SEARCH REPORT

| International application No. |
|---|
| PCT/JP2007/055577 |

A. CLASSIFICATION OF SUBJECT MATTER
*C30B29/38*(2006.01)i, *C30B23/08*(2006.01)i, *H01L21/205*(2006.01)i

According to International Patent Classification (IPC) or to both national classification and IPC

B. FIELDS SEARCHED

Minimum documentation searched (classification system followed by classification symbols)
C30B29/38, C30B23/08, H01L21/205

Documentation searched other than minimum documentation to the extent that such documents are included in the fields searched
Jitsuyo Shinan Koho          1922-1996    Jitsuyo Shinan Toroku Koho    1996-2007
Kokai Jitsuyo Shinan Koho    1971-2007    Toroku Jitsuyo Shinan Koho    1994-2007

Electronic data base consulted during the international search (name of data base and, where practicable, search terms used)
Science Direct, JSTPlus(JDream2)

C. DOCUMENTS CONSIDERED TO BE RELEVANT

| Category* | Citation of document, with indication, where appropriate, of the relevant passages | Relevant to claim No. |
|---|---|---|
| X | JP 2005-522889 A (The Regents of the University of California), 28 July, 2005 (28.07.05), Claims; Par. Nos. [0022] to [0027], [0053] & US 2003/0198837 A1 & US 2003/0230235 A1 & US 2005/0040385 A1 & US 2005/0245095 A1 | 1,4-6,8-16, 21-25,35,36, 38-40 |
| Y | Atsushi KOBAYASHI, Yuji KAWAGUCHI, Jitsuo OTA, Hiroshi FUJIOKA, "Shitsuon Seicho Buffer So o Mochiita ZnO Kibanjo Kibanjo GaN Usumaku no Kohinshitsuka", Journal of the Japanese Association of Crystal Growth, 17 August, 2005 (17.08.05), Vol.32, No.3, page 152, [17pb13] | 1-40,43-45 |

☒ Further documents are listed in the continuation of Box C.          ☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered   to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 11 May, 2007 (11.05.07) | 22 May, 2007 (22.05.07) |

| Name and mailing address of the ISA/ Japanese Patent Office | Authorized officer |
|---|---|
| Facsimile No. | Telephone No. |

Form PCT/ISA/210 (second sheet) (April 2005)

**INTERNATIONAL SEARCH REPORT**

International application No.

PCT/JP2007/055577

C (Continuation).   DOCUMENTS CONSIDERED TO BE RELEVANT

| Category* | Citation of document, with indication, where appropriate, of the relevant passages | Relevant to claim No. |
|---|---|---|
| Y | Atsushi KOBAYASHI, Jitsuo OTA, Masaharu OJIMA, Hiroshi FUJIOKA, "Shitsuon Seicho Buffer So o Mochiita GaN ZnO Hetero Kozo no Sakusei to Hyoka", Dai 52 kai Oyo Butsurigaku Kankei Rengo Koenkai Koen Yokoshu, 29 March, 2005 (29.03.05), Vol.52$^{nd}$, No.1, page 415, [31a-L-19] | 1-40,43-45 |
| Y | Takeshi Ohgaki, et al, Structure and properties of GaN films grown on single crystalline ZnO substrates by molecular beam epitaxy, Journal of Crystal Growth, 2005, Vol.275, p.e1143-e1148 | 1-40,43-45 |
| A | ATUSHI KOBAYASHI, et al, Room temperature Layer by Layer Growth of GaN on Atomically Flat ZnO, Japanese Journal of Applied Physics, 2004, Vol.43, No.1A/B, p.L53-L55 | 1-45 |
| P,X | A. Kobayashi, et al, Room temperature epitaxial growth of m-plane GaN on lattice-matched ZnO substrates, Appl. Phys. Lett. 2007.01.23, Vol.90 , p.041908 | 1-40,43-45 |

Form PCT/ISA/210 (continuation of second sheet) (April 2005)

**EP 2 009 148 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2005075651 A

**Non-patent literature cited in the description**

- *66th Annual Meeting of Japan Society of Applied Physics, Conference Proceedings,* 2005, 11
- *Appl. Phys. Lett.,* 17 March 2003, vol. 82 (11), 1793-1795
- *Journal of Crystal Growth,* 2005, vol. 275, e1143-e1148
- *Journal of Crystal Growth,* 1998, vol. 193, 127-132
- *Japanese Journal of Applied Physics,* 2004, vol. 43, L53-L55
- *Applied Physics Letters,* 2003, vol. 83 (25), 5208-5210
- *J. Vac. Sci. Technol.,* 1999, vol. 17 (4), 1654